# EUROPEAN PATENT APPLICATION

(11) **EP 4 807 740 A1**
(43) Date of publication of application: **16.09.2026**
(21) Application number: 26157817.3
(22) Date of filing: 11.02.2026
(51) Int. Cl.: G11C 5/02, G11C 7/12, G11C 7/18, G11C 11/412, G11C 11/419

(54) **SEMICONDUCTOR MEMORY DEVICE WITH STRAP ELEMENT**

(30) Priority: 12.03.2025 KR 20250032228; 02.07.2025 KR 20250088667
(71) Applicant: Samsung Electronics Co., Ltd., Suwon-si, Gyeonggi-do 16677 (KR)
(72) Inventor: TANG, Hoyoung, 16677 Suwon-si, Gyeonggi-do (KR); LEE, Eojin, 16677 Suwon-si, Gyeonggi-do (KR); BAECK, Sang-Yeop, 16677 Suwon-si, Gyeonggi-do (KR); KIM, Tae-Hyung, 16677 Suwon-si, Gyeonggi-do (KR)
(74) Representative: Kuhnen & Wacker Patent- und Rechtsanwaltsbüro PartG mbB

(57) **Abstract**

A memory device includes a memory cell array including memory cells arranged in a matrix, the memory cell array including a first memory cell (MCₚ) and a second memory cell (MCₚ₊₁) arranged in a column direction, a first bitline and a second bitline connected to the first memory cell (MCₚ) and the second memory cell (MCₚ₊₁), and a strap circuit (SC) provided between the first memory cell (MCₚ) and the second memory cell (MCₚ₊₁). Each of the first and second bitlines includes a first sub-bitline (BLₐ, BL'ₐ) connected to the strap circuit (SC) and the first memory cell (MCₚ), a second sub-bitline (BL_{b}, BL'_{b}) connected to the strap circuit (SC) and the second memory cell (MCₚ₊₁), and a third sub-bitline (BL_{c}, BL'_{c}) connected to the strap circuit (SC) through the first sub-bitline (BLₐ, BL'ₐ).

## Description

### BACKGROUND

A static random access memory (SRAM) device includes bitlines and complementary bitlines from which voltages are output from memory cells. The SRAM device may determine a value of data stored in a memory cell by comparing voltages at a bitline and a complementary bitline. However, as process scaling advances, the pre-charge speed of bitlines and complementary bitlines has become a critical factor in determining the operational performance of memory devices.

### SUMMARY

Implementations of the present disclosure provide an SRAM device with increased pre-charge speed of bitlines and complementary bitlines.

According to one or more implementations, a memory device includes a memory cell array including memory cells arranged in a matrix, the memory cell array including a first memory cell and a second memory cell arranged in a column direction, a first bitline and a second bitline connected to the first memory cell and the second memory cell, and a strap element (strap circuit) provided between the first memory cell and the second memory cell. Each of the first and second bitlines includes a first sub-bitline connected to the strap element and the first memory cell, a second sub-bitline connected to the strap element and the second memory cell, and a third sub-bitline connected to the strap element through the first sub-bitline.

According to one or more implementations, a memory device includes a first memory cell array comprising first memory cells, a second memory cell array comprising second memory cells, bitlines respectively connected to the first and second memory cells, and a strap element (strap circuit) provided between the first and second memory cell arrays. Each of the bitline may includes a first sub-bitline connected to the first memory cells, a second sub-bitline connected to the second memory cells, and a third sub-bitline connected to the first sub-bitline. The first sub-bitline may be connected to the third sub-bitline with the strap element interposed therebetween.

### BRIEF DESCRIPTION OF DRAWINGS

FIG. 1 is a block diagram illustrating a memory device according to one or more implementations.
FIG. 2 is a schematic circuit diagram illustrating a memory device according to one or more implementations.
FIG. 3 is an equivalent circuit diagram of a memory cell according to one or more implementations.
FIG. 4 is a block diagram illustrating a memory cell array in detail.
FIG. 5 is a schematic diagram illustrating a portion of FIG. 4.
FIGS. 6A and 6B are diagrams, respectively illustrating cases in which locations of strap elements are different from those of the above-described implementation.
FIGS. 7A and 7B are diagrams, respectively illustrating cases in which arrangement and connection relationship of bitlines are different from those of the above-described implementation.
FIG. 8 is a schematic cross-sectional view of a plurality of layers included in a memory device according to one or more implementations.
FIGS. 9A and 9B are schematic layout diagrams, each illustrating a portion of a memory device according to one or more implementations.
FIG. 10 is a circuit diagram of a strap element according to one or more implementation.
FIGS. 11A and 11B are plan views, each illustrating a portion of a memory device employing the strap element of FIG. 10.
FIGS. 12A-12C are cross-sectional views along lines A-A', B-B', and C-C' of FIG. 11A, respectively.
FIG. 13 is a plan view illustrating a memory device according to one or more implementation.
FIGS. 14A, 15A, 16A, 17A, 18A, 19A, 20A, 21A, 22A, 23A, 24A, 25A, 26A, 27A are circuit diagrams illustrating strap elements according to one or more implementations, and FIGS. 14B, 15B, 16B, 17B, 18B, 19B, 20B, 21B, 22B, 23B, 24B, 25B, 26B, 27B are plan views of memory devices including the strap elements illustrated in FIGS. 14A, 15A, 16A, 17A, 18A, 19A, 20A, 21A, 22A, 23A, 24A, 25A, 26A, 27A.

### DETAILED DESCRIPTION

The following description with reference to the accompanying drawings is provided to assist in a comprehensive understanding of various implementations of the present disclosure.

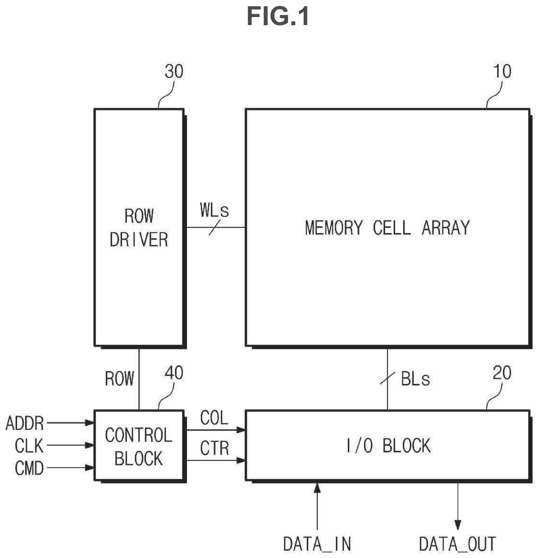

FIG. 1 is a block diagram illustrating a memory device according to one or more implementations.

Referring to FIG. 1, a memory device may receive a command CMD, an address ADDR, and a clock CLK, and may perform a write operation and a read operation. For example, the memory device may receive a command CMD indicating a write operation, an address, and write data DATA_IN, and may store the write data DATA_IN in a region of a memory cell array 10 corresponding to the address. In addition, the memory device may receive a command CMD indicating a read operation and an address, and may output read data DATA_OUT, stored in the region of the memory cell array 10 corresponding to the address, to an external device.

The memory cell array 10 may include a plurality of memory cells. Each of the plurality of memory cells may be connected to a single wordline among a plurality of wordlines WLs, and may be connected to at least one bitline among a plurality of bitlines BLs. In one or more implementations, each memory cell may be a static random access memory (SRAM) device.

A row driver 30 may be connected to the memory cell array 10 through the plurality of wordlines WLs. The row driver 30 may activate one of the plurality of wordlines WLs based on a row address ROW. Accordingly, the memory cells connected to the activated wordline WL among the plurality of memory cells may be selected.

A control block 40 may receive the command CMD, the address ADDR, and the clock CLK, and may generate a row address ROW, a column address COL, and a control signal CTR. For example, the control block 40 may identify a read command by decoding the command CMD, and may generate a read signal as the row address ROW, the column address COL, and the control signal CTR to read the read data DATA_OUT from the memory cell array 10. In addition, the control block 40 may identify a write command by decoding the command CMD, and may generate a write signal as the row address ROW, the column address COL, and the control signal CTR to write the data DATA_IN to the memory cell array 10.

An input/output block 20 may include a pre-charge circuit, a sense amplifier, a column driver, a read circuit, and a write circuit.

According to one or more implementations, the memory device may further include another device/circuit module (for example, a logic device, a high-frequency device, an image sensing device, a dynamic random access memory DRAM device, or combinations thereof).

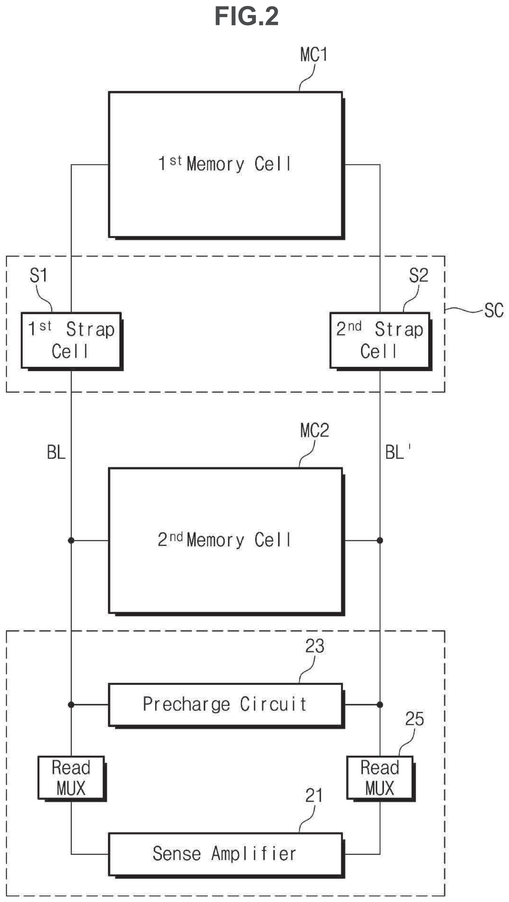

FIG. 2 is a schematic circuit diagram illustrating a memory device according to one or more implementations.

Referring to FIG. 2, the memory device may include memory cells, a pre-charge circuit 23, a sense amplifier 21, a read multiplexer 25, and a strap element (strap circuit) SC. The pre-charge circuit 23, the sense amplifier 21, and the read multiplexer 25 may be included in the input/output block 20.

The memory cells include a first memory cell MC1 and a second memory cell MC2. Each of the first memory cell MC1 and the second memory cell MC2 may be a memory cell including at least one or more PMOS transistors and at least one or more NMOS transistors. Each memory cell selected through the read multiplexer 25 may be connected to a pair of complementary bitlines BL and BL', and may sense a difference between signals, output from the pair of bitlines, to determine data. The pair of complementary bitlines may be referred to as a bitline (or a first bitline BL) and a complementary bitline (or a second bitline BL').

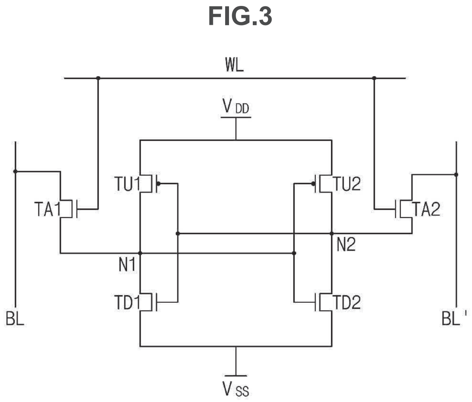

FIG. 3 is an equivalent circuit diagram of the first memory cell or the second memory cell illustrated in FIG. 2.

Referring to FIG. 3, a memory cell may include a first pull-up transistor TU1, a first pull-down transistor TD1, a second pull-up transistor TU2, a second pull-down transistor TD2, a first access transistor TA1, and a second access transistor TA2. The first and second pull-up transistors TU1 and TU2 may be PMOS transistors. The first and second pull-down transistors TD1 and TD2 and the first and second access transistors TA1 and TA2 may be NMOS transistors.

A first source/drain of the first pull-up transistor TU1 and a first source/drain of the first pull-down transistor TD1 may be connected to a first node N1. A second source/drain of the first pull-up transistor TU1 may be connected to a power supply line Vdd, and a second source/drain of the first pull-down transistor TD1 may be connected to a ground line Vss. A gate of the first pull-up transistor TU1 and a gate of the first pull-down transistor TD1 may be electrically connected to each other. The first pull-up transistor TU1 and the first pull-down transistor TD1 may form a first inverter. The connected gates of the first pull-up and first pull-down transistors TU1 and TD1 may correspond to an input terminal of the first inverter, and the first node N1 may correspond to an output terminal of the first inverter.

A first source/drain of the second pull-up transistor TU2 and a first source/drain of the second pull-down transistor TD2 may be connected to a second node N2. A second source/drain of the second pull-up transistor TU2 may be connected to the power supply line Vdd, and a second source/drain of the second pull-down transistor TD2 may be connected to the ground line Vss. A gate of the second pull-up transistor TU2 and a gate of the second pull-down transistor TD2 may be electrically connected to each other. Thus, the second pull-up transistor TU2 and the second pull-down transistor TD2 may form a second inverter. The connected gates of the second pull-up and second pull-down transistors TU2 and TD2 may correspond to an input terminal of the second inverter, and the second node N2 may correspond to an output terminal of the second inverter.

The first and second inverters may be combined to form a latch structure. For example, the gates of the first pull-up and first pull-down transistors TU1 and TD1 may be electrically connected to the second node N2, and the gates of the second pull-up and second pull-down transistors TU2 and TD2 may be electrically connected to the first node N1. A first source/drain of the first access transistor TA1 may be connected to the first node N1, and a second source/drain of the first access transistor TA1 may be connected to a bitline BL. A first source/drain of the second access transistor TA2 may be connected to the second node N2, and a second source/drain of the second access transistor TA2 may be connected to a complementary bitline BL'. The gates of the first and second access transistors TA1, TA2 may be electrically connected to a wordline WL. Accordingly, a memory cell according to one or more implementations may be implemented.

Returning to FIG. 2, the pre-charge circuit is connected to the first memory cell MC1 and the second memory cell MC2 through the pair of bitlines BL and BL'.

The pre-charge circuit 23 may pre-charge and equalize the pair of bitlines BL and BL' in response to a strap cell control signal. In one or more implementations, the pre-charge circuit 23 may transfer a voltage (for example, a power supply voltage, or the like), supplied from an external entity, to the pair of bitlines BL and BL'. The pre-charge circuit 23 may transfer a pre-charge voltage to the pair of bitlines BL and BL'.

The strap element SC is arranged between the first memory cell MC1 and the second memory cell MC2, and may connect or disconnect the first memory cell MC1 and the second memory cell MC2 in response to a strap element control signal as a switching element. In one or more implementations, the strap element SC may include a first strap cell S1 connected to a bitline BL and a second strap cell S2 connected to a complementary bitline BL'. Each of the first strap cell S1 and the second strap cell S2 may include at least one PMOS transistor, at least one NMOS transistor, a transmission gate, and combinations thereof. This will be described later with the accompanying drawings.

The sense amplifier 21 may sense a voltage difference of the bitline pair BL and BL' to sense data stored in a memory cell. In one or more implementations, the sense amplifier 21 may be a differential type sense amplifier. The sense amplifier 21 may output a sensed result as a signal. The sense amplifier 21 may include PMOS transistors and NMOS transistors.

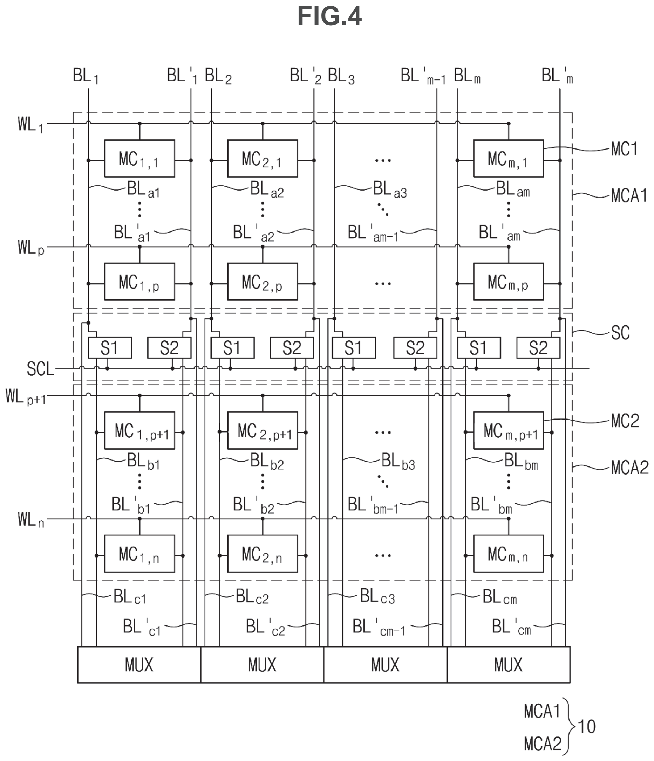

FIG. 4 is a block diagram illustrating a memory cell array in detail.

Referring to FIG. 4, a memory device includes a memory cell array. The memory cell array may include a plurality of memory cells arranged in a matrix of rows and columns. In FIG. 4, a memory cell array having n rows (where n is a positive integer) and m columns (where m is a positive integer) is illustrated. A memory cell corresponding to an m-th column of an n-th row is denoted in the form of "MC_{n,m}" for ease of description.

The memory cell array may include a first memory cell array MCA1 and a second memory cell array MCA2. The first memory cell array MCA1 may include the memory cells from a first row to a p-th row (p<n, p is a positive integer), and the second memory cell array MCA2 may include the memory cells from a (p+1)-th row to an n-th row.

Each of the memory cells may be disposed at an intersection of a row and a column and may have an internal data state. The memory cells may be accessed based on a row-by-row basis to read data and/or write data to the internal data states of the accessed memory cells during operation of the memory device.

The wordlines WL (WL₁ to WLₙ) may be provided in a number of rows of the memory cell array, for example, n. Each of the wordlines WL, to WLₙ may be connected to memory cells of a corresponding row. For example, a p-th wordline WLp may be connected to memory cells MC_{1,p} to MC_{m,p} of the p-th row. In FIG. 4, the n-th wordline is illustrated as WLₙ for ease of description. In some implementations, a row decoder may be connected to the wordlines WL, to WLₙ and may be configured to selectively enable the wordlines WL, to WLₙ based on address signals.

The bitline pairs BL and BL' may enable a read operation from the accessed memory cells and/or a write operation to the accessed memory cells. The bitline pairs BL and BL' may be connected to memory cells corresponding to each column. For example, a pair of bitlines, for example, a bitline BL and a complementary bitline BL', may be connected to the memory cells corresponding to each column. In FIG. 4, a bitline of the m-th column is illustrated as BLₘ for ease of description. For example, an m-th bitline BLₘ and an m-th complementary bitline BL'ₘ are connected to the memory cells MC_{m,1} to MC_{m,n} of the m-th column.

A bitline BL corresponding to each column may include a first sub-bitline BLₐ connected to the memory cells of the first memory cell array MCA1, a second sub-bitline BL_{b} connected to the memory cells of the second memory cell array MCA2, and a third sub-bitline BL_{c} connected to the first sub-bitline BLₐ. A complementary bitline corresponding to each column may include a first sub-complementary bitline BL'ₐ connected to the memory cells of the first memory cell array MCA1, a second sub-complementary bitline BL'_{b} connected to the memory cells of the second memory cell array MCA2, and a third sub-complementary bitline BL'_{c} connected to the first sub-complementary bitline BL'ₐ.

The strap elements SC may be provided between the first memory cell array MCA1 and the second memory cell array MCA2. The strap elements SC may be provided between memory cells of a last row of the first memory cell array MCA1 and the memory cell of a first row of the second memory cell array MCA2. The strap elements SC may include first strap cells S1 connected to the bitline BL and second strap cells S2 connected to the complementary bitline BL'. In each column, the first strap cell S1 may be provided between the first sub-bitline BLₐ and the second sub-bitline BL_{b}, and the second strap cell S2 may be provided between the first sub-complementary bitline BL'ₐ and the second sub-complementary bitline BL'_{b}. The third sub-bitline BL_{c} may be connected to the first strap cell S1 through the first sub-bitline BLₐ, and the third sub-complementary bitline BL'_{c} may be connected to the second strap cell S2 through the first sub-complementary bitline BL'ₐ.

The first strap cells S1 and the second strap cells S2 may be connected to a strap cell control line SCL, and the strap elements SC may be a switching element connecting or disconnecting a portion of the bitlines BL and/or the complementary bitlines BL' in response to a strap element control signal.

A source of the first strap cell S1 may be connected to the first sub-bitline BLₐ and the third sub-bitline BL_{c}, and a drain of the first strap cell S1 may be connected to the second sub-bitline BL_{b}. A source of the second strap cell S2 may be connected to the first sub-complementary bitline BL'ₐ and the third sub-complementary bitline BL'_{c}, and a drain of the second strap cell S2 may be connected to the second sub-complementary bitline BL_{'}b. For example, the first strap cell S1 may connect or disconnect the first sub-bitline BLₐ and the third sub-bitline BL_{c} to/from the second sub-bitline BL_{b} in response to a strap cell control signal. The second strap cell S2 may connect or disconnect the first sub-complementary bitline BL'ₐ and the third sub-complementary bitline BL'_{c} to/from the second sub-complementary bitline BL'_{b} in response to a strap cell control signal.

The bitlines BL and the complementary bitlines BL' may be connected to a multiplexer MUX provided in an input/output block (see FIG. 1). The multiplexer MUX may output data transmitted from the bitline BL and the complementary bitline BL' or data transmitted from the complementary bitline BL and the complementary bitline BL' based on an applied selection signal.

As described above, the strap elements may connect or disconnect a pair of bitlines provided in a corresponding column by a strap control signal. Accordingly, pre-charging between a plurality of memory cell arrays may be synchronized. For example, the strap elements may simultaneously pre-charge the bitline pairs of the plurality of memory cell arrays by transmitting a pre-charge state of a first memory cell array to a second array or sharing the pre-charge state vice versa. The strap elements may be maintained at the same voltage level of the bitlines and the complementary bitlines connected to the plurality of memory cell arrays, which may reduce a timing issue when the plurality of memory cell arrays are addressed. In addition, when the strap elements are provided between the plurality of memory cell arrays, a load of the bitlines which may vary depending on a location of the memory cell arrays of the bitlines/complementary bitlines may be reduced, which may lead to low power consumption of the memory device.

Accordingly, the bitlines within the memory device may be easily and rapidly pre-charged, enabling reliable operation of the memory device.

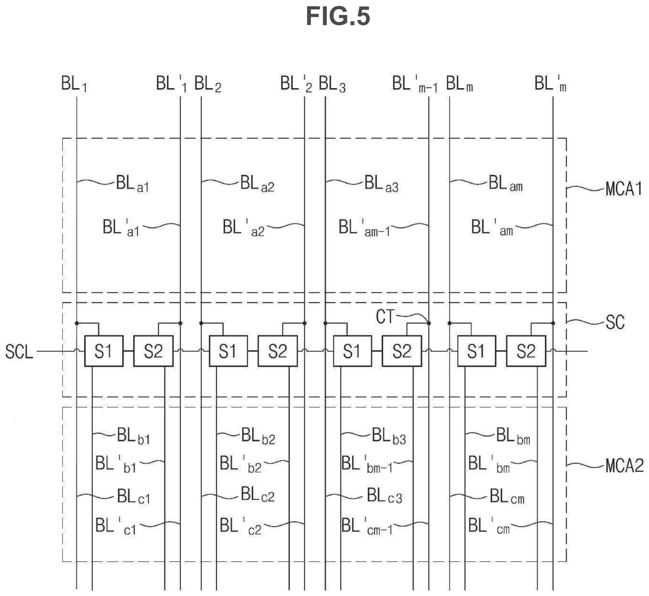

FIG. 5 is a schematic diagram illustrating a portion of FIG. 4. In FIG. 5, a first memory cell array MCA1, a second memory cell array MCA2, strap elements SC, and bitlines BL, BL' are illustrated, and the other components are omitted.

Referring to FIGS. 4 and 5, the first sub-bitlines BLₐ may extend from the memory cells of the first row MC_{1,1} to MC_{m,1} to the memory cells of the p-th row MC_{1,p} to MC_{m,p} in a direction in which a column of the memory cell array extends to correspond to each corresponding column. The first sub-bitlines BLₐ may further extend from the memory cells of the p-th row MC_{1,p} to MC_{m,p} to be electrically connected to sources of the first strap cells S1. The first sub-complementary bitlines BL'ₐ may also extend from the memory cells of the first row MC_{1,1} to MC_{m,1} to the memory cells of the p-th row MC_{1,p} to MC_{m,p} in the direction in which the column of the memory cell array extends to correspond to each corresponding column. The first sub-complementary bitlines BL'a may further extend from the memory cells of the p-th row MC_{1,p} to MC_{m,p} to be electrically connected to sources of the second strap cells S2.

Each of the first sub-bitlines BLₐ and the first sub-complementary bitlines BL'ₐ may be connected to the first memory cells MC1 of a corresponding row of the first memory cell array MCA1.

The second sub-bitlines BL_{b} may extend from the memory cells of the (p+1)-th row MC_{1,p+1} to MC_{m,p+1} to the memory cells of the n-th row MC_{1,n} to MC_{m,n} in the direction in which the column of the memory cell array extends to correspond to each column. The first sub-bitlines BLₐ may further extend from the memory cells of the (p+1)-th row MC_{1,p+1} to MC_{m,p+1} in a direction of the p-th row memory cells MC_{1,p} to MC_{m,p} to be electrically connected to drains of the first strap cells S1. The second sub-complementary bitlines BL'b may also extend from the memory cells of the (p+1)-th row MC_{1,p+1} to MC_{m,p+1} to the memory cells of the n-th row MC_{1,n} to MC_{m,n} in the direction in which the column of the memory cell array extends to correspond to each corresponding column. The second sub-complementary bitlines BL'b may further extend from the memory cells of the (p+1)-th row MC_{1,p+1} to MC_{m,p+1} in the direction of the memory cells of the p-th row MC_{1,p} to MC_{m,p} to be electrically connected to drains of the second strap cells S2.

Each of the second sub-bitlines BLb and the second sub-complementary bitlines BL'b may be connected to the second memory cells MC2 of a corresponding row of the second memory cell array MCA2.

The third sub-bitlines BLc may extend from the memory cells of the (p+1)-th row MC_{1,p+1} to MC_{m,p+1} to the memory cells of the n-th row in the direction in which the column of the memory cell array extends to correspond to each column. The third sub-bitlines BL_{c} may further extend from the memory cells of the (p+1)-th row MC_{1,p+1} to MC_{m,p+1} in the direction of the p-th row memory cells MC_{1,p} to MC_{m,p} extend to be electrically connected to the first sub-bitlines BLa and the sources of the first strap cells S1. The third sub-complementary bitlines BL'_{c} may also extend from the memory cells of the (p+1)-th row MC_{1,p+1} to MC_{m,p+1} to the memory cells of the n-th row MC_{1,n} to MC_{m,n} in the direction in which the column of the memory cell array extends to correspond to each corresponding column. The third sub-complementary bitlines BL'_{c} may further extend from the memory cells of the (p+1)-th row MC_{1,p+1} to MC_{m,p+1} in the direction of the memory cells of the p-th row MC1,p, MC2,p, ..., MCm,p to be electrically connected to the first sub-complementary bitlines BL'a and the sources of the second strap cells S2.

In one or more implementations, the third sub-bitlines BL_{c} and the third sub-complementary bitlines BL'_{c} may be not connected to the second memory cells MC2 of the second memory cell array MCA2.

In one or more implementations, the first sub-bitlines BLₐ and the second sub-bitlines BL_{b} may be vertically disposed at the same level.

The phrase "being vertically disposed at the same level" may refer to a case in which two components are disposed at the same height from a predetermined reference plane, or a case in which two components, among sequentially stacked layers, are disposed on the same layer although the two components are not disposed at the same height from a substrate surface. For example, when two components are disposed on the same insulating layer, the two components may be considered to be vertically disposed at the same level. The phrase "being disposed at different levels" may refer to a case in which two components are disposed at different heights from a predetermined reference plane, or a case in which two components, among sequentially stacked layers, are disposed on different layers.

In one or more implementations, the third sub-bitlines BLc may be vertically disposed at a level different from a level of the second sub-bitlines BL_{b}, and the third sub-complementary bitlines BL'_{c} may be disposed at a level different from a level of the second sub-complementary bitlines BL'_{b}. End portions of the third sub-bitlines BL_{c} on the side of the first sub-bitlines BLₐ may be electrically connected to the first sub-bitlines BLₐ through a vertical contact structure, respectively. End portions of the third sub-complementary bitlines BL'_{c} on the side of the first sub-complementary bitlines BL'ₐ may be electrically connected to the first sub-complementary bitlines BL'ₐ through a vertical contact structure, respectively. The contact structures of the third sub-bitlines BL_{c} and the first sub-bitlines BLₐ and the contact structures of the third sub-complementary bitlines BL'_{c} and the first sub-complementary bitlines BL'ₐ may have a multilayer staircase shape.

In one or more implementations, the strap cell control line SCL may extend in a row direction between the first memory cell array MCA1 and the second memory cell array MCA2. The strap cell control line SCL may extend in a direction of extension from the memory cells of a first column MC_{1,1} to MC_{1,n} to the memory cells of an m-th column MC_{m,1} to MC_{m,n}. The strap cell control line SCL may be disposed at different vertical levels from the first sub-bitlines BLₐ, the second sub-bitlines BL_{b}, and the third sub-bitlines BL_{c}.

For example, the strap cell control line SCL may be vertically disposed at a higher level than the first sub-bitlines/sub-complementary bitlines BLₐ/BL'ₐ and the second sub-bitlines/sub-complementary bitlines BL_{b}/BL'_{b}. In addition, the strap cell control line SCL may be disposed at a lower level than the third sub-bitlines/sub-complementary bitlines BL_{c}/BL'_{c}.

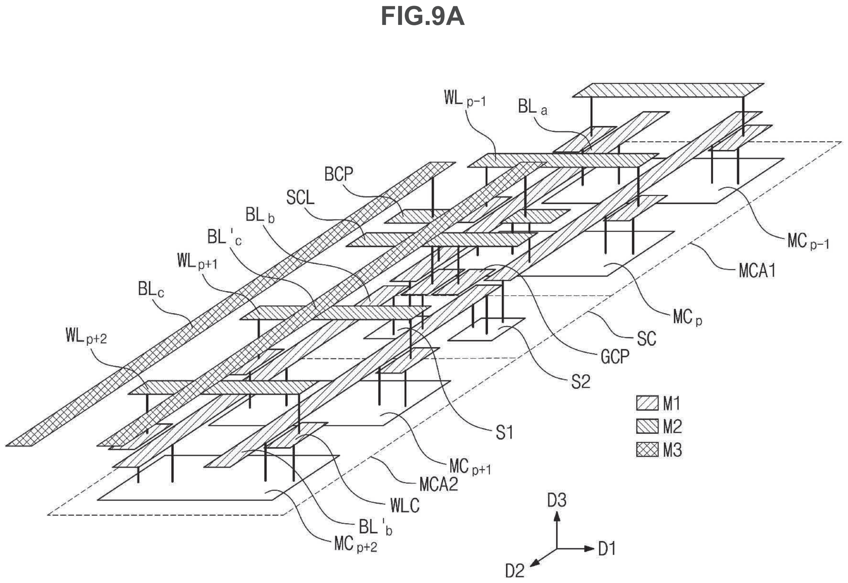

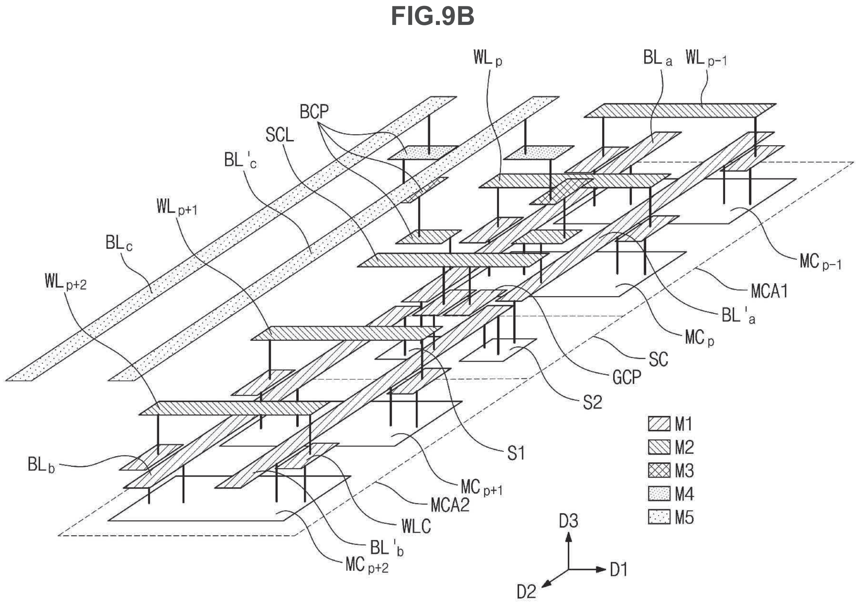

A vertical structure of the bitlines and the strap elements SC will be described later with reference to FIGS. 9A and 9B.

In one or more implementations, the locations of the strap elements SC may be different in various forms. For example, the number of memory cells in the first memory cell array MCA1 and the number of memory cells in the second memory cell array MCA2 may be the same. The number of columns of the first memory cell array MCA1 may be the same as the number of columns of the second memory cell array MCA2, and the number of rows in the first memory cell array MCA1 may be the same as the number of rows in the second memory cell array MCA2. For example, when the first memory cell array MCA1 has p rows and the second memory cell array MCA2 has n-p rows, p may correspond to (1/2)n. However, the location of the strap element SC may be set to be different depending on the number of memory cells in the first memory cell array MCA1 or the second memory cell array MCA2, or a load of the bitlines corresponding to each memory cell array.

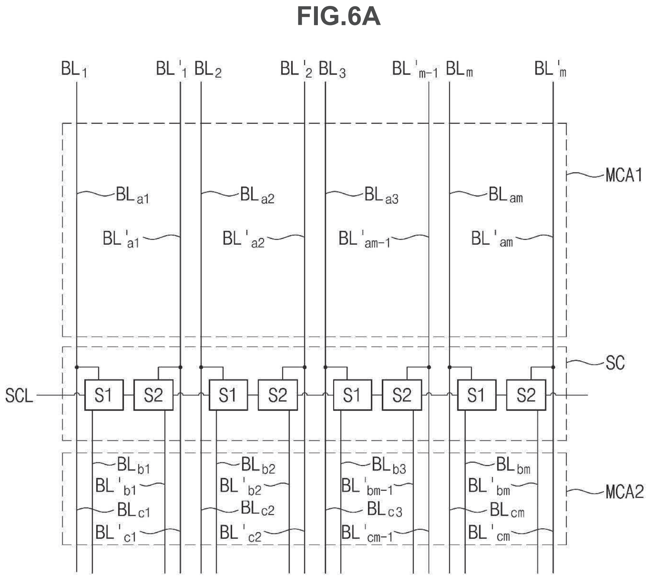

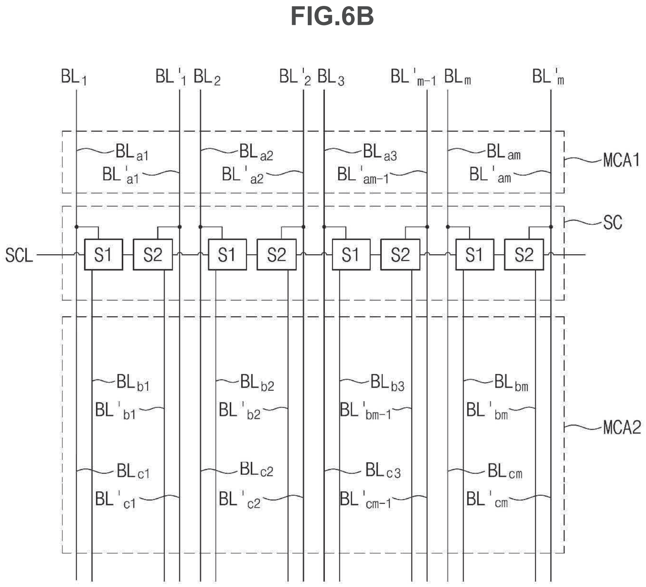

FIGS. 6A and 6B are diagrams, respectively illustrating cases in which locations of strap elements are different from those of the above-described implementation.

Referring to FIG. 6A, the number of rows of the first memory cell array MCA1 may be greater than the number of rows of the second memory cell array MCA2. For example, when the first memory cell array MCA1 has p rows and the second memory cell array MCA2 has n-p rows, p may be greater than (1/2)n.

Referring to FIG. 6B, the number of rows of the first memory cell array MCA1 may be smaller than the number of rows of the second memory cell array MCA2. For example, when the first memory cell array MCA1 has p rows and the second memory cell array MCA2 has n-p rows, p may be smaller than (1/2)n.

As illustrated in FIGS. 6A and 6B, the location of the strap element may be set to be different depending on the load of the bitlines corresponding to each memory cell array. Thus, the load of the bitlines corresponding to each memory cell array may be significantly reduced.

In one or more implementations, an arrangement or a connection relationship of the first to third sub-bitlines BLₐ, BL_{b}, and BL_{c} and the strap elements SC may be provided to be different from those of the above-described implementation. For example, connection structures between the first to third sub-bitlines BLₐ, BL_{b}, and BL_{c} may be formed to be different from each other.

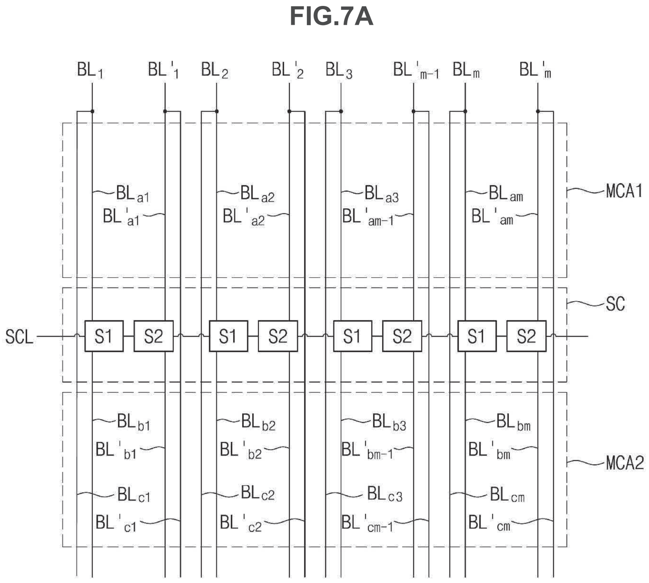

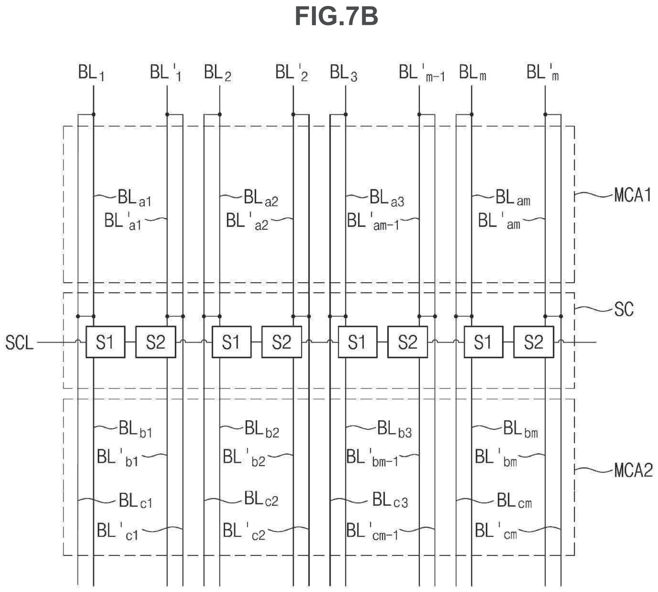

FIGS. 7A and 7B are diagrams, respectively illustrating cases in which arrangement and connection relationship of bitlines are different from those of the above-described implementation.

Referring to FIGS. 4 and 7A, the first sub-bitlines BLₐ and the first sub-complementary bitlines BL'ₐ may extend in a direction in which columns of the memory cell array extends to correspond to each column, and may be connected to the memory cells MC1 of the corresponding row of the first memory cell array MCA1, respectively.

The second sub-bitlines BL_{b} and the second sub-complementary bitlines BL'b may extend in a direction in which columns of the memory cell array extends to correspond to each column, and may be connected to the memory cells of the corresponding row of the second memory cell array MCA2, respectively.

The third sub-bitline BL_{c} may be connected to the first sub-bitlines BLₐ between the first memory cell array MCA1 and the second memory cell array MCA2, or in a region spaced apart from the second memory cell array MCA2 with the first memory cell array MCA1 interposed therebetween. The third sub-complementary bitline BL'_{c} also may be connected to the first sub-complementary bitlines BL'ₐ between the first memory cell array MCA1 and the second memory cell array MCA2, or in a region spaced apart from the second memory cell array MCA2 with the first memory cell array MCA1 interposed therebetween.

For example, the third sub-bitlines BLc may extend from the memory cells of the first row MC_{1,1} to MC_{m,1} to the memory cells of the n-th row MC_{1,n} to MC_{m,n} in the direction in which the column of the memory cell array extends to correspond to each column. The third sub-bitlines BLc may further extend from the memory cells of the first row MC_{1,1} to MC_{m,1} to an external side of the first memory cell array MCA1 to be electrically connected to the first sub-bitlines BLₐ. As the third sub-bitlines BL_{c} are electrically connected to the first sub-bitlines BLₐ, the third sub-bitlines BL_{c} may be electrically connected to sources of the first strap cells S1.

The third sub-complementary bitlines BL'_{c} may also extend from the memory cells of the first row MC_{1,1} to MC_{m,1} to the memory cells of the n-th row MC_{1,n} to MC_{m,n} in the direction in which the column of the memory cell array extends to correspond to each column. The third sub-complementary bitlines BL'_{c} may further extend from the memory cells of the first row MC_{1,1} to MC_{m,1} to an external side of the first memory cell array MCA1 to be electrically connected to the first sub-complementary bitlines BL'ₐ. As the third sub-complementary bitlines BL'_{c} are electrically connected to the first sub-complementary bitlines BL'ₐ, the third sub-complementary bitlines BL'_{c} may be connected to sources of the second strap cells S2.

In one or more implementations, the third sub-bitlines BL_{c} and the first sub-bitlines BLₐ may be connected to the first sub-bitlines BLₐ through a vertical contact structure, respectively. End portions of the third sub-complementary bitlines BL'_{c} on the side of the first sub-complementary bitlines BL'ₐ may be connected to the first sub-complementary bitlines through a vertical contact structure, respectively. The contact structures of the third sub-bitlines BL_{c} and the first sub-bitlines BLₐ, and the contact structures of the third sub-complementary bitlines BL'_{c} and the first sub-complementary bitlines BL'ₐ may have a multilayer staircase shape.

Referring to FIGS. 4 and 7B, the first sub-bitlines BLₐ and the first sub-complementary bitlines BL'ₐ may extend in a direction in which the column of the memory cell array extends to correspond to each column, and may be connected to the memory cells MC1 of the corresponding row of the first memory cell array MCA1, respectively.

The second sub-bitlines BL_{b} and the second sub-complementary bitlines BL'_{b} may extend in a direction in which the column of the memory cell array extends to correspond to each column, and may be connected to the memory cells of the corresponding row of the second memory cell array MCA2, respectively.

The third sub-bitlines BL_{c} may extend from the memory cells of the first row MC_{1,1} to MC_{m,1} to the memory cells of the n-th row MC_{1,n} to MC_{m,n} in a direction in which the column direction of the memory cell array extends to correspond to each column. The third sub-bitlines BL_{c} may be electrically connected to the first sub-bitlines BLₐ between the first memory cell array MCA1 and the second memory cell array MCA2. In addition, the third sub-bitlines BL_{c} may further extend from the memory cells of the first row MC_{1,1} to MC_{m,1} to an external side of the first memory cell array MCA1 to be electrically connected to the first sub-bitlines BLa. As the third sub-bitlines BL_{c} are electrically connected to the first sub-bitlines BLₐ at two locations, the third sub-bitlines BL_{c} may be stably connected to the sources of the first strap cells S1.

The third sub-complementary bitlines BL'_{c} may also extend from the memory cells of the first row MC_{1,1} to MC_{m,1} to the memory cells of the n-th row MC_{1,n} to MC_{m,n} in a direction in which the column of the memory cell array extends to correspond to each column. The third sub-complementary bitlines BL'_{c} may be electrically connected to the first sub-complementary bitlines BL'ₐ between the first memory cell array MCA1 and the second memory cell array MCA2. In addition, the third sub-complementary bitlines BL'_{c} may further extend from the memory cells of the first row MC_{1,1} to MC_{m,1} to an external side of the first memory cell array MCA1 and to be electrically connected to the first sub-complementary bitlines. As the third sub-complementary bitlines BL'_{c} are electrically connected to the first sub-complementary bitlines BL'ₐ at two locations, the third sub-complementary bitlines BL'_{c} may be stably connected to the sources of the second strap cells S2.

In one or more implementations, the third sub-bitlines BL_{c} and the first sub-bitlines BLₐ may be connected to the first sub-bitlines BLₐ through two vertical contact structures, respectively. End portions of the third sub-complementary bitlines BL'_{c} on the side of the first sub-complementary bitlines BL'ₐ may also be connected to the first sub-complementary bitlines through two vertical contact structures, respectively. The contact structures of the third sub-bitlines BL_{c} and the first sub-bitlines BLₐ, and the contact structures of the third sub-complementary bitlines BL'_{c} and the first sub-complementary bitlines BL'ₐ may have a multilayer staircase shape.

As described above, bitlines according to one or more implementations may be connected to each other through a vertical contact structure of a plurality of layers included in the memory device.

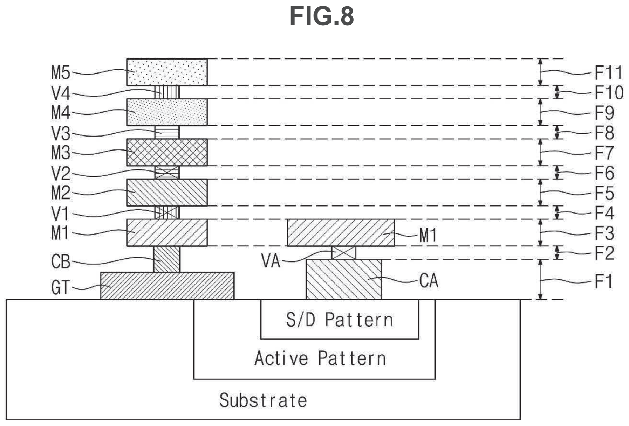

FIG. 8 is a schematic cross-sectional view of a plurality of layers included in a memory device according to one or more implementations.

The plurality of layers may be formed on a semiconductor chip or various types of substrates, for example, a wafer. FIG. 8 schematically illustrates a plurality of levels of interconnection structures and transistors, and may not reflect an actual cross-sectional view of the memory device. In the following, for clarity, transistors are omitted and sizes of a gate electrode GT, an active contact CA, a gate contact CB, an active via VA, first to fifth metal wirings M1 to M5 and first to fourth vias V1 to V4 are arbitrarily illustrated.

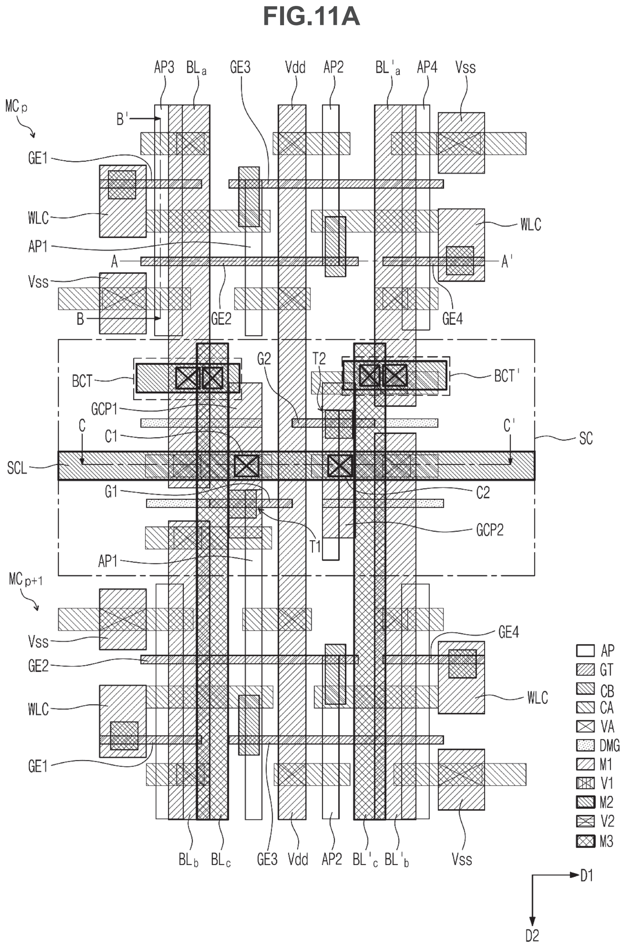

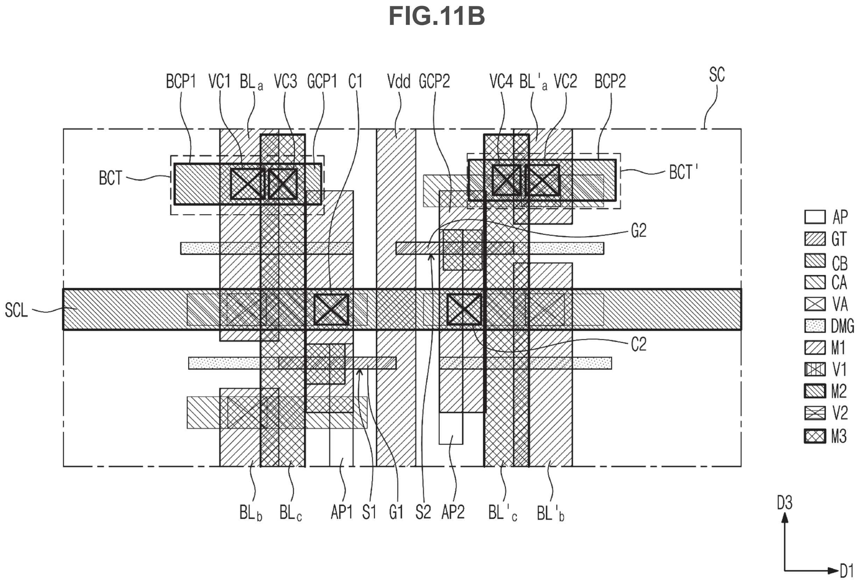

Referring to FIG. 8, the gate electrode GT and the active contact CA connected to a source/drain region of a transistor may be formed on a first layer F1. The first layer F1 may be referred to as a 'contact layer.' The first layer F1 may be formed in a front end-of-line (FEOL) process. The gate electrode GT may correspond to the gate electrodes of FIG. 11 to be described later.

The gate contact CB may be provided on the gate electrode GT. A level of an upper surface of the gate contact CB may be the same as a level of an upper surface of the active contact CA. For example, a height of the active contact CA may be the same as a height of the first layer F1, and a sum of a height of the gate electrode GT and a height of the gate contact CB may be the same as the height of the first layer F1.

The gate contact CB may connect the gate electrode GT and a first metal wiring M1. The active via VA connected to the active contact CA may be formed on a second layer F2. The second layer F2 may be referred to as a 'contact via layer' or a 'V0 layer.' A sum of the height of the gate electrode GT and the gate contact CB may be the same as a sum of a height of the active contact CA and a height of the active via VA.

The first metal wiring M1 may be formed on a third layer F3. The metal wiring M1 may be formed on each of the gate contact CB and the active via VA.

A first via V1 may be formed in a fourth layer F4. The first via V1 may connect the first metal wiring M1 and a second metal wiring M2. The fourth layer may be referred to as a 'first via V1 layer.' The first via V1 may be formed on the gate electrode GT, and may not be formed on the active contact CA.

The second metal wiring M2 may be formed on a fifth layer F5. The fifth layer F5 may be referred to as a 'second wiring layer M2.'

A second via V2 may be formed on a sixth layer F6. The second via V2 may connect the second metal wiring M2 and a third metal wiring M3. The sixth layer F6 may be referred to as a 'second via V2 layer.'

The third metal wiring M3 may be formed on a seventh layer F7. The seventh layer F7 may be referred to as a 'third wiring layer M3.'

A third via V3 may be formed on an eighth layer F8. The third via V3 may connect the third metal wiring M3 and a fourth metal wiring M4. The eighth layer F8 may be referred to as a 'third via layer.'

The fourth metal wiring M4 may be formed on a ninth layer F9. The ninth layer F9 may be referred to as a 'fourth wiring layer.'

A fourth via V4 may be formed on a tenth layer F10. The fourth via V4 may connect the fourth metal wiring M4 and a fifth metal wiring M5. The tenth layer F10 may be referred to as a 'fourth via layer.'

The fifth metal wiring M5 may be formed on an eleventh layer F11. The eleventh layer F11 may be referred to as a 'fifth wiring layer.'

The second to eleventh layers F2 to F11 may be formed in a back end-of-line (BEOL) process. A contact area may decrease from the second layer F2 toward the eleventh layer F11.

Hereinafter, a layout of the metal wirings having the stacked structure of FIG. 8 will be described.

FIGS. 9A and 9B are schematic layout diagrams, each illustrating a portion of a memory device according to one or more implementations. For clarity, FIGS. 9A and 9B illustrate a portion of one column of a memory cell array is illustrated for ease of description, and illustrate only two memory cells (for example, a (p-1)-th memory cell MCₚ₋₁) and a p-th memory cell MCₚ in a first memory cell array MCA1, a strap element (strap circuit) SC, and two memory cells (for example, a (p+1)-th memory cell MCp+1 and a (p+2)-th memory cell CMₚ₊₂ in a second memory cell array MCA2). In addition, an active contact CA, an active via VA, a gate contact CB, and first to fourth vias are all represented by vertical lines.

Hereinafter, a direction in which a row extends is defined as a first direction D1, a direction in which a column extends is defined as a second direction D2, and a direction perpendicular to the first direction D1 and the second direction D2 is defined as a third direction D3.

Referring to FIGS. 8 and 9A, the first memory cell array MCA1, the strap element SC, and the second memory cell array MCA2 may be sequentially disposed in the second direction D2. The first memory cell array MCA1 may include first memory cells, and the second memory cell MC2 array may include second memory cells. In the present implementation, the first memory cells may correspond to the (p-1)-th memory cell MCₚ₋₁ and the p-th memory cell MCₚ, and the second memory cells correspond to the (p+1)-th memory cell MCₚ₊₁ and the (p+2)-th memory cell MCₚ₊₂.

A bitline and a complementary bitline may be connected to each memory cell. The bitline and the complementary bitline may be connected through an active contact and an active via of each memory cell.

A bitline may include a first sub-bitline BLₐ and a second sub-bitline BL_{b} formed of a first metal wiring M1 and a third sub-bitline BLc formed of a third metal wiring M3. Accordingly, the third sub-bitline BL_{c} may be vertically disposed at a level different from levels of the first and second sub-bitlines BLₐ and BL_{b}. For example, the third sub-bitline BL_{c} may be vertically disposed at a higher level than the first and second sub-bitlines BLₐ and BL_{b}.

A complementary bitline may include a first sub-complementary bitline BL'ₐ and a second sub-complementary bitline BL'_{b} formed of the first metal wiring M1 and a third sub-complementary bitline BL'_{c} formed of the third metal wiring M3. Accordingly, the third sub-complementary bitline BL'_{c} may be vertically disposed at a level different from levels of the first and second sub-complementary bitlines BL'ₐ and BL'_{b}. For example, the third sub-complementary bitline BL'_{c} may be vertically disposed at a higher level than the first and second sub-complementary bitlines BL'ₐ and BL'_{b}.

The first and second sub-bitlines BLₐ and BL_{b} may be sequentially disposed in the second direction D2, and may be spaced apart from each other in a region in which the strap element SC is provided. The first and second sub-complementary bitlines BL'ₐ and BL'_{b} also may be sequentially disposed in the second direction D2, and may be spaced apart from each other in the region in which the strap element SC is provided. The first sub-bitline BLa and the first sub-complementary bitline BL'a may be disposed to be spaced apart from each other in the first direction D1. The second sub-bitline BL_{b} and the second sub-complementary bitline BL'_{b} may also be disposed to be spaced apart from each other in the first direction D1.

The third sub-bitline BL_{c} may be connected to the first sub-bitline BLₐ with a bitline connection pattern BCP, formed on a second wiring layer M2, interposed therebetween. The third sub-complementary bitline BL'_{c} may be connected to the first sub-complementary bitline BL'ₐ with a bitline connection pattern BCP, formed on the second wiring layer M2, interposed therebetween.

Wordlines are connected to each memory cell. The wordlines may extend in the first direction D1. The wordlines may be formed of the second metal wiring M2. The wordlines may be connected to corresponding memory cells with a wordline connection pattern WLC, formed on a first wiring layer M1, interposed therebetween. For example, a (p-1)-th wordline WLₚ₋₁, a p-th wordline WLₚ, a (p+1)-th wordline WLₚ₊₁, and a (p+2)-th wordline WLₚ₊₂ may be connected to the (p-1)-th memory cell MCₚ₋₁, the p-th memory cell MCₚ, the (p+1)-th memory cell MCₚ₊₁, and the (p+2)-th memory cell MCₚ₊₂, respectively.

The wordlines may be provided at a vertically different level, for example, a higher level, than the first and second sub-bitlines BLₐ and BL_{b} and the first and second sub-complementary bitlines BL'ₐ and BL'_{b}. In addition, the wordlines may be provided at a vertically different level, for example, a lower level, than the third sub-bitlines BL_{c} and the third sub-complementary bitlines.

The strap element SC may include a first strap cell S1 and a second strap cell S2. The first strap cell S1 and the second strop cell S2 may be spaced apart from each other in the first direction D1.

The first sub-bitline BLₐ, the second sub-bitline BL_{b}, and the strap cell control line SCL may be connected to the first strap cell S1, and the first sub-complementary bitline BL'ₐ, the second sub-complementary bitline BL'_{b}, and the strap cell control line SCL may be connected to the second strap cell S2. For example, an end portion of the first sub-bitline BLₐ and an end portion of the second sub-bitline BL_{b} may each be connected to the first strap cell S1 in a region in which the strap element SC is provided, and an end portion of the first sub-complementary bitline BL'ₐ and an end portion of the second sub-complementary bitline BL'_{b} may each be connected to the second strap cell S2.

The strap cell control line SCL may be formed of the second metal wiring M2. The strap cell control line SCL may be connected to the first strap cell S1 and the second strap cell S2 through a strap cell gate connection pattern GCP formed on the first wiring layer M1. The strap cell control line SCL may be provided at a vertically same level as the wordlines, and may be spaced apart from the wordlines along the second direction D2.

In one or more implementations, a portion of wirings forming the memory device may be provided at a level different from that of the above-described implementation. For example, the third sub-bitline BL_{c} and the third sub-complementary bitline BL'_{c} may be provided on a layer other than the third wiring layer M3.

Referring to FIGS. 8 and 9B, a bitline may include a first sub-bitline BLₐ and a second sub-bitline BL_{b} formed of the first metal wiring M1, and a third sub-bitline BL_{c} formed of a fifth metal wiring M5. Accordingly, the third sub-bitline BL_{c} may be vertically disposed at a higher level than the first and second sub-bitlines BLₐ and BL_{b}.

A complementary bitline may also include a first sub-complementary bitline BL'ₐ and a second sub-complementary bitline BL'_{b} formed of the first metal wiring M1, and a third sub-complementary bitline BL'_{c} formed of the fifth metal wiring M5. Accordingly, the third sub-complementary bitline BL'_{c} may be vertically disposed at a higher level than the first and second sub-complementary bitlines BL'ₐ and BL'_{b}.

The third sub-bitline BL_{c} may be connected to the first sub-bitline BLₐ with bitline connection patterns BL_{c}, formed on a second wiring layer M2, a third wiring layer M3, and a fourth wiring layer, interposed therebetween. The third sub-complementary bitline BL'_{c} may also be connected to the first sub-complementary bitline BL'ₐ with bitline connection patterns BCP, formed on a second wiring layer M2, a third wiring layer M3, and a fourth wiring layer M4, interposed therebetween.

In the present implementation, the third sub-bitline BL_{c} and the third sub-complementary bitline BL'_{c} are illustrated as being formed on the fifth wiring layer M5, but implementations are not limited thereto. For example, the third sub-bitline BL_{c} and the third sub-complementary bitline BL'_{c} may be formed on a seventh wiring layer M7, and may be connected to each other through a plurality of bitline connection patterns BCP. In addition, other wirings besides the third sub-bitline BL_{c} may be formed on a layer other than the above-described layer. For example, in the above-described implementation, the wordlines are illustrated as being formed on the third wiring layer M3, but implementations are not limited thereto, and the wordlines may be formed on the fifth wiring layer M5.

In one or more implementations, the strap elements may be implemented with various types of switching elements.

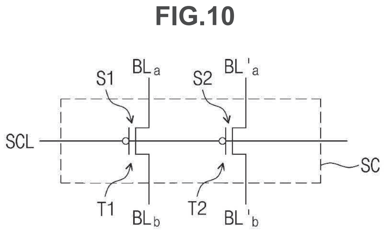

FIG. 10 is a circuit diagram of a strap element (strap circuit) according to one or more implementation.

Referring to FIG. 10, a strap element SC may include a PMOS transistor connected to a bitline as a first strap cell S1 and a PMOS transistor connected to a complementary bitline as a second strap cell S2. For example, the first sub-bitline BLₐ may be connected to a source of the first strap cell S1 and the second sub-bitline BL_{b} may be connected to a drain thereof, and the first sub-complementary bitline BL'ₐ may be connected to a source of the second strap cell S2 and the second sub-complementary bitline BL'_{b} may be connected to a drain thereof. Gates of the first strap cell S1 and the second strap cell S2 may be connected to a strap cell control line SCL. The first strap cell S1 and the second strap cell S2 may pre-charge/equalize a bitline and a complementary bitline in response to a strap cell control signal.

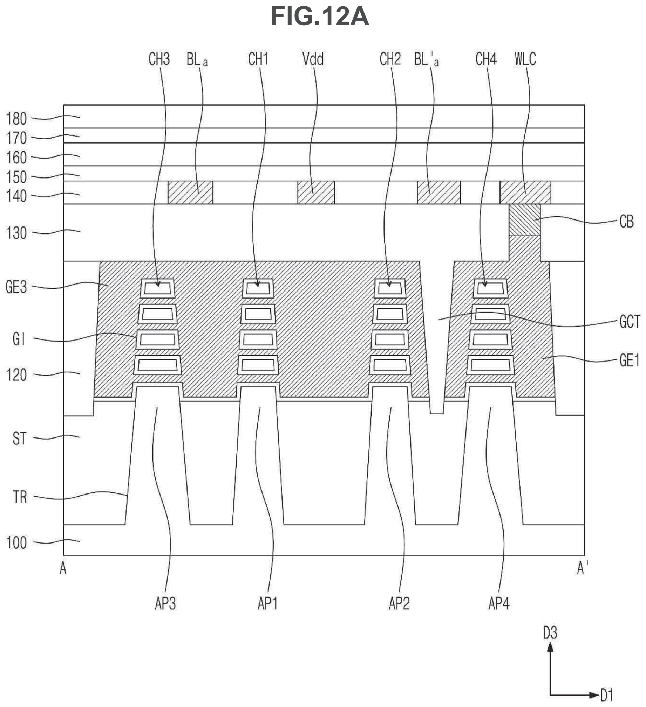

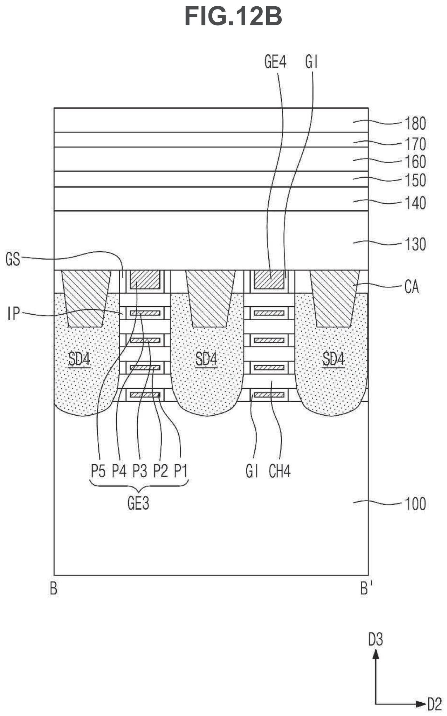

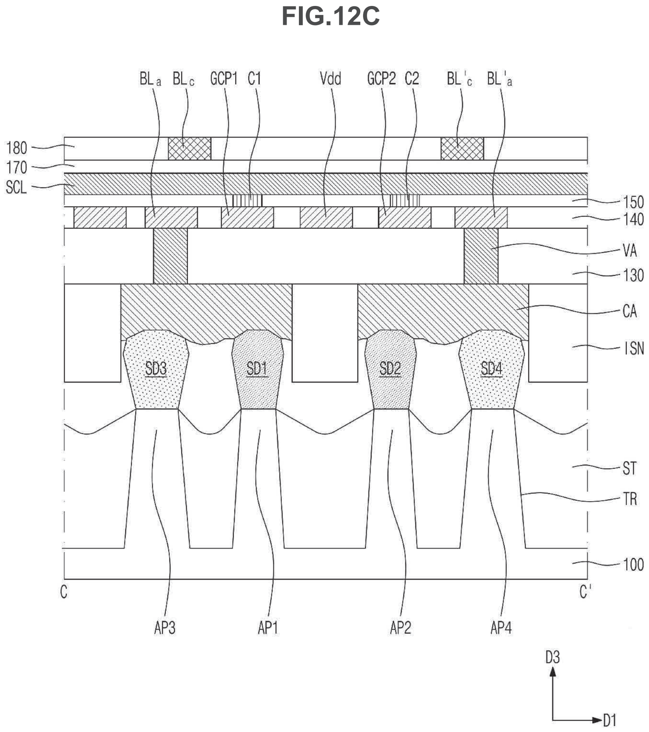

FIGS. 11A and 11B are plan views, each illustrating a portion of a memory device employing the strap element of FIG. 10. In FIG. 11A, for ease of description, only a strap element (strap circuit) and two memory cells (a p-th memory cell and a (p+1)-th memory cell) of the same column adjacent to the strap element are illustrated, and some components (for example, wordlines and ground lines in the third wiring layer) are omitted. FIG. 11B is an enlarged plan view of a portion of the strap element of FIG. 11A. FIGS. 12A-12C are cross-sectional views along lines A-A', B-B', and C-C' of FIG. 11A, respectively.

Referring to FIGS. 11A, 11B, and 12A to 12C, a memory cell may be provided on a substrate 100.

In one or more implementations, a plurality of memory cells may be provided on the substrate 100. The memory cells may form a first memory cell array MCA1 and a second memory cell array MCA2 with a strap element (strap circuit) SC interposed therebetween. The memory cells in the first memory cell array MCA1 and the memory cells in the second memory cell array MCA2 may be disposed in a matrix form on the substrate 100, and two adjacent memory cells in a row direction and/or a column direction may have a substantially mirror-symmetrical shape. The first memory cell array MCA1 and the second memory cell array MCA2 may be spaced apart from each other along the second direction D2, and the strap element SC may be disposed between the first memory cell array MCA1 and the second memory cell array MCA2.

In the following, for ease of description, the p-th memory cell is referred to as a first memory cell MC1, the (p+1)-th memory cell is referred to as a second memory cell MC2, a region in which the first memory cell MC1 is provided is referred to as a first memory cell region, a region in which the second memory cell MC2 is provided is referred to as a second memory cell region, and a region in which the strap element SC is provided is referred to as a strap element region.

The substrate 100 may be a semiconductor substrate including silicon, germanium, silicon-germanium, or a compound semiconductor substrate. The substrate 100 may include a single-crystalline semiconductor material such as Si, Ge, SiGe, GaAs, InSb, GaP, GaSb, InAlAs, InGaAs, GaSbP, GaAsSb, or InP, but implementations are not limited thereto. For example, the substrate 100 may be a silicon substrate.

A plurality of active patterns, for example, AP1, AP2, AP3, and AP4, may be defined by a trench TR formed in the substrate 100.

A first active pattern AP1 and a second active pattern AP2 may correspond to a PMOS transistor region, and a third active pattern AP3 and a fourth active pattern AP4 may correspond to an NMOS transistor region.

In one or more implementations, in the drawings, an NMOS transistor region in which the third active pattern AP3 is provided, a PMOS transistor region in which the first and second active patterns AP1 and AP2 are provided, and an NMOS transistor region in which the fourth active pattern AP4 is provided are sequentially disposed in the first direction D1. However, this is only an example, and an arrangement of the NMOS transistor region and the PMOS transistor region may be different therefrom.

In one or more implementations, the substrate 100 may be a P-type substrate or an N-type substrate. When the substrate 100 is the P-type substrate, the first active pattern AP1 and the second active pattern AP2 may be provided in an N-well of the substrate 100. When the substrate 100 is the N-type substrate, the third active pattern AP3 and the fourth active pattern AP4 may be provided in a P-well of the substrate 100. Alternatively, both an N-well and a P-well may be formed in the substrate 100. In this case, the first active pattern AP1 and the second active pattern AP2 may be provided in the N-well of the substrate 100, and the third active pattern AP3 and the fourth active pattern AP4 may be provided in the P-well of the substrate 100.

The first to fourth active patterns AP1, AP2, AP3, and AP4 may extend in the second direction D2. The first to fourth active patterns AP1, AP2, AP3, and AP4 may be vertically protruding portions as a portion of the substrate 100. The first to fourth active patterns AP1, AP2, AP3, and AP4 may be disposed with a predetermined interval in the first direction D1 in the order of the third active pattern AP3, the first active pattern AP1, the second active pattern AP2, and the fourth active pattern AP4.

The first to fourth active patterns AP1, AP2, AP3, and AP4 may extend in the second direction D2, and each of the first to fourth active patterns AP1, AP2, AP3, and AP4 may be provided in a form of two or more separated patterns. For example, at least a portion of the first to fourth active patterns AP1, AP2, AP3, and AP4 may be disposed to extend from the first memory cell region and/or the second memory cell region into the strap element region. Alternatively, another portion of the first to fourth active patterns AP1, AP2, AP3, and AP4 may be provided in the strap element SC to be spaced apart from the active patterns of the first memory cell region and/or the second memory cell region.

An isolation layer ST may fill the trenches TR. The isolation layer ST may include a silicon oxide layer. Upper portions of the first to fourth active patterns AP1, AP2, AP3, and AP4 may vertically protrude upwardly of the isolation layer ST. The isolation layer ST may not cover the upper portions of the first to fourth active patterns AP1, AP2, AP3, and AP4. The isolation layer ST may cover lower side surfaces of the first to fourth active patterns AP1, AP2, AP3, and AP4.

A first to fourth channel pattern CH1, CH2, CH3, and CH4 may be provided on the first to fourth active patterns AP1, AP2, AP3, and AP4, respectively. The first and second channel patterns CH1 and CH2 may be provided on the PMOS transistor region in which the first and second active patterns AP1 and AP2 are provided, and the third and fourth channel patterns CH3 and CH4 may be provided on the NMOS transistor region in which where the third and fourth active patterns AP3 and AP4 are provided. Each of the first to fourth channel patterns CH1, CH2, CH3, and CH4 may include sequentially stacked semiconductor patterns. The semiconductor patterns may be spaced apart from each other in a vertical direction (for example, the third direction D3).

A plurality of recesses may be formed on an upper portion of the first active pattern AP1. The first source/drain patterns SD1 may be respectively provided in the recesses. The first source/drain patterns SD1 may be impurity regions of a first conductive type for example, P-type. A first channel pattern CH1 may be interposed between a pair of the first source/drain patterns SD1. The first channel pattern CH1 may include stacked semiconductor patterns. The first channel pattern CH1 may connect the pair of the first source/drain patterns SD1 to each other.

A plurality of recesses may be formed on an upper portion of each of the second to fourth active patterns AP2, AP3, and AP4 to have the same shape. Second to fourth source/drain patterns SD2, SD3, and SD4 may be provided in the recesses, respectively. The second source/drain patterns SD2 may be impurity regions of the first conductivity type (for example, P-type). The third and fourth source/drain patterns SD3 and SD4 may be impurity regions of a second conductivity type (for example, N-type).

The first to fourth source/drain patterns SD1, SD2, SD3, and SD4 may be epitaxial patterns formed by a selective epitaxial growth SEG process. For example, an upper surface of each of the first to fourth source/drain patterns SD1, SD2, SD3, and SD4 may be disposed at substantially the same level as an upper surface of an uppermost semiconductor pattern. For example, an upper surface of each of the first to fourth source/drain patterns SD1, SD2, SD3, and SD4 may be higher than an upper surface of a topmost semiconductor pattern SP.

The first to fourth source/drain patterns SD1, SD2, SD3, and SD4 may include the same semiconductor element as, or a different semiconductor element from, the substrate 100. The first and second source/drain patterns SD1 and SD2 may include a semiconductor element (for example, SiGe) having a larger lattice constant than the semiconductor element of the substrate 100. Thus, a pair of first source/drain patterns SD1 may provide a compressive stress to the first channel pattern CH1 between the pair of the first source/drain patterns SD1. In addition, a pair of second source/drain patterns SD2 may provide a compressive stress to the second channel pattern CH2 between the pair of second source/drain patterns SD2. The third and fourth source/drain patterns SD3 and SD4 may include the same semiconductor element (for example, Si) as the substrate 100. For example, the third and fourth source/drain patterns SD3 and SD4 may include single-crystalline silicon.

In the first and second memory cell regions, first to fourth gate electrodes GE1, GE2, GE3, and GE4 may be provided to extend in the first direction D1 crossing the first to fourth active patterns AP1, AP2, AP3, and AP4. In plan view, a first gate electrode GE1 may cross a third active pattern AP3, a second gate electrode GE2 may cross the third active pattern AP3 and the first active pattern AP1, a third gate electrode GE3 may cross the first active pattern AP1 and the fourth active pattern AP4, and a fourth gate electrode GE4 may cross the fourth active pattern AP4.

In the strap element region, a first strap cell gate electrode G1 and a second strap cell gate electrode G2 may be provided to extend in the first direction D1 crossing the first active pattern AP1 and the second active pattern AP2. The first active pattern AP1 and the second active pattern AP2 may be spaced apart from each other in the second direction D2. The first strap cell gate electrode G1 may vertically overlap the first channel pattern, and the second strap cell gate electrode G2 may vertically overlap the second channel pattern.

The first strap cell gate electrode G1 on the second active pattern AP2 may be a gate of a first transistor T1 forming a first strap cell S1, and the second strap cell gate electrode G2 on the second active pattern AP2 may be a gate of a second transistor T2 forming a second strap cell S2.

The first to fourth gate electrodes GE1, GE2, GE3, and GE4 and the first and second strap cell gate electrodes G1 and G2 may each include at least one of a conductive metal nitride (for example, titanium nitride or tantalum nitride) and a metal material (for example, titanium, tantalum, tungsten, copper, or aluminum).

A reference numeral "DMG" refers to a dummy gate electrode having substantially the same layout as the strap cell gate electrodes but having no electrical function.

In the first memory cell region and the second memory cell region, the first gate electrode GE1 and the third gate electrode GE3 may be disposed side by side in the first direction D1. The second gate electrode GE2 and the fourth gate electrode GE4 may be disposed side by side in the first direction D1. A second interlayer dielectric 120 including a gate cutting pattern GCT may be interposed between the first gate electrode GE1 and the third gate electrode GE3 as a gate cutting region, so that the first gate electrode GE1 and the third gate electrode GE3 may be separated from each other. In addition, a second interlayer dielectric 120 including a gate cutting pattern GCT may be interposed between the second gate electrode GE2 and the fourth gate electrode GE4 as a gate cutting region, so that the second gate electrode GE2 and the fourth gate electrode GE4 may be separated from each other.

In the strap element region, the first strap cell gate electrode G1 and the second strap cell gate electrode G2 may respectively extend in the first direction D1. The first strap cell gate electrode G1 and the second strap cell gate electrode G2 may be spaced apart from each other in the second direction D2.

In the first memory cell region and the second memory cell region, the first gate electrode GE1 may vertically overlap the third channel pattern CH3, and the second gate electrode GE2 may vertically overlap the third, first, and second channel patterns CH3, CH1, and CH2 in order in the first direction D1. The third gate electrode GE3 may vertically overlap the first, second, and fourth channel patterns CH1, CH2, and CH4, and the fourth gate electrode GE4 may vertically overlap the fourth channel pattern CH4.

In the strap element region, the first strap cell gate electrode G1 may vertically overlap the third channel pattern, and the second strap cell gate electrode G2 may vertically overlap the first channel pattern.

In the first memory cell region and the second memory cell region, the first gate electrode GE1 on the third active pattern AP3 may be a gate of a first access transistor TA1. The second gate electrode GE2 on the third active pattern AP3 may be a gate of a second pull-down transistor TD2, and the second gate electrode GE2 on the first active pattern AP1 may be a gate of a first pull-up transistor TU1. The third gate electrode GE3 on the second active pattern AP2 may be a gate of a second pull-up transistor TU2, and the third gate electrode GE3 on the fourth active pattern AP4 may be a gate of a first pull-down transistor TD1. The fourth gate electrode GE4 on the fourth active pattern AP4 may be a second access transistor TA2.

The first to fourth gate electrodes GE1, GE2, GE3, and GE4 and the first and second strap cell gate electrodes G1 and G2 may each include first to fifth portions P1, P2, P3, P4, and P5 formed between the substrate 100 and the semiconductor patterns, between adjacent semiconductor patterns, and on the topmost semiconductor pattern. The first to fourth gate electrodes GE1, GE2, GE3, and GE4 and the first and second strap cell gate electrodes G1 and G2 may each be provided on an upper surface, a bottom surface, and opposite side surfaces of each of the semiconductor patterns. For example, an SRAM transistor according to the present implementation may be a three-dimensional field effect transistor (for example, a multi-bridge channel field-effect transistor (MBCFET)) in which each gate electrode three-dimensionally surrounds a channel.

A pair of gate spacers GS may be disposed on opposite side surfaces of each of the first to fourth gate electrodes GE1, GE2, GE3, and GE4 and the first and second strap cell gate electrodes G1 and G2. The gate spacers GS may extend in the first direction D1 along each gate electrode. The gate spacers GS may include at least one of SiCN, SiCON, and SiN. For example, the gate spacers GS may having a multilayer structure including at least two of SiCN, SiCON, and SiN.

A gate insulating layer GI may be interposed between each of the first to fourth gate electrodes GE1, GE2, GE3, and GE4 and the first and second strap cell gate electrodes G1 and G2 and each of the first to fourth channel patterns CH1, CH2, CH3, and CH4. The gate insulating layer GI may cover an upper surface, a bottom surface, and opposite side surfaces of each of the semiconductor patterns. The gate insulating layer GI may cover an upper surface of the isolation layer ST below the gate electrode.

The gate insulating layer GI may include an interface layer directly covering a surface of each of the first to fourth channel patterns CH1, CH2, CH3, CH4, and a high-k layer on the interface layer. The high-κ layer may include a high-κ material having a higher dielectric constant than a silicon oxide layer. For example, the high-κ material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate. In one or more implementations, the high-κ layer may have a greater thickness than the interface layer. The interface layer may include a silicon oxide layer or a silicon oxynitride layer.

The first to fourth gate electrodes GE1, GE2, GE3, and GE4 and the first and second strap cell gate electrodes G1 and G2 may each include a first metal pattern, a second metal pattern, and an electrode pattern. The first metal pattern may be provided on the gate insulating layer GI. For example, the gate insulating layer GI may be interposed between the first metal pattern and the second channel pattern CH2.

The first metal pattern may include a metal nitride having a relatively high work function. For example, the first metal pattern may include a P-type work function metal. For example, the first metal pattern may include titanium nitride (TiN), tantalum nitride (TaN), titanium oxynitride (TiON), titanium silicon nitride (TiSiN), titanium aluminum nitride (TiAIN), tungsten carbon nitride (WCN), or molybdenum nitride (MoN). The second metal pattern may be provided on the first metal pattern. The second metal pattern may cover a recessed upper surface of the first metal pattern. The second metal pattern may include a metal carbide having a relatively low work function. For example, the second metal pattern may include an N-type work function metal. The second metal pattern may include a metal carbide doped with (or containing) silicon and/or aluminum. For example, the second metal pattern may include aluminum-doped titanium carbide (TiAIC), aluminum-doped tantalum carbide (TaAIC), aluminum-doped vanadium carbide (VAIC), silicon-doped titanium carbide (TiSiC), or silicon-doped tantalum carbide (TaSiC). Alternatively, the second metal pattern may include titanium carbide (TiAlSiC) doped with aluminum and silicon, or tantalum carbide (TaAlSiC) doped with aluminum and silicon. Alternatively, the second metal pattern may include aluminum-doped titanium (TiAl). The electrode pattern may be provided on the second metal pattern. The electrode pattern may have a lower resistance than the first and second metal patterns. For example, the electrode pattern may include at least one low-resistance metal of aluminum (Al), tungsten (W), titanium (Ti), or tantalum (Ta).

Inner spacers IP may be provided between the first to fourth source/drain patterns SD1, SD2, SD3, and SD4 and the first and second strap cell gate electrodes G1 and G2. The inner spacers IP may be respectively interposed between the first to fifth portions P1 to P5 of a portion of the first to fourth gate electrodes GE1, GE2, GE3, and GE4 and the first and second strap cell gate electrodes G1 and G2 and the first to fourth source/drain patterns SD1, SD2, SD3, and SD4. The inner spacers IP may directly contact each of the first to fourth source/drain patterns SD1, SD2, SD3, and SD4. The first to fifth portions P1 to P5 of a portion of the gate electrodes may be spaced apart from each of the first to fourth source/drain patterns SD1, SD2, SD3, and SD4 by an inner spacer IP. The inner spacers IP may include one of SiN, SiCN, or SiOCN.

In the strap element region, the first strap cell gate electrode G1 on the first active pattern AP1 and the source/drain patterns provided on opposite sides of the first strap cell gate electrode G1 form a first transistor T1, and the second strap cell gate electrode G2 on the second active pattern AP2 and the source/drain patterns provided on opposite sides of the second strap cell gate electrode G2 form a second transistor T2.

A first interlayer dielectric 110 may be provided on the substrate 100. The first interlayer dielectric 110 may be provided on the isolation layer ST and may cover a portion of the first to fourth source/drain patterns SD1, SD2, SD3, and SD4.

A second interlayer dielectric 120 including a gate cutting pattern GCT may be provided on the first interlayer dielectric 110. The second interlayer dielectric 120 may be provided on a portion of the first interlayer dielectric 110. For example, the second interlayer dielectric 120 may be provided in a region other than a region in which the first to fourth gate electrodes GE1, GE2, GE3, and GE4, the first and second strap cell gate electrodes G1 and G2, and the first to fourth source/drain patterns SD1, SD2, SD3, and SD4 are formed.

An active contact (CA) isolation pattern ISN may be provided on the second interlayer dielectric 120. The active contact (CA) isolation pattern ISN may be provided in a region, other than a region in which the active contacts CA are formed, to isolate the active contacts CA from each other.

The active contacts CA may be provided on the first to fourth source/drain patterns SD1, SD2, SD3, and SD4. The active contacts CA may be electrically connected to corresponding source/drain patterns among the first to fourth source/drain patterns SD1, SD2, SD3, and SD4.

Each of the active contacts CA may include a conductive pattern and a barrier pattern surrounding the conductive pattern. For example, the conductive pattern may include at least one metal of aluminum, copper, tungsten, molybdenum, or cobalt. The barrier pattern may cover side surfaces and a bottom surface of the conductive pattern. The barrier pattern may include a metal layer/metal nitride layer. The metal layer may include at least one of titanium, tantalum, tungsten, nickel, cobalt, or platinum. The metal nitride layer may include at least one of a titanium nitride layer (TiN), a tantalum nitride layer (TaN), a tungsten nitride layer (WN), a nickel nitride layer (NiN(, a cobalt nitride layer CoN, or a platinum nitride layer (PtN).

A third interlayer dielectric 130 may be provided on the active contacts CA.

Active vias VA may be provided in the third interlayer dielectric 130. The active vias VA may be provided on the active contacts CA. In addition, gate contact patterns CB may be provided in the third interlayer dielectric 130. The gate contact patterns CB may be provided on the corresponding gate electrodes. Upper surfaces of the active contacts CA and the gate electrodes may be vertically disposed at different levels. In one or more implementations, upper surfaces of the active vias VA and the gate contact patterns CB may be coplanar with an upper surface of the third interlayer dielectric 130.

A fourth interlayer dielectric 140 may be provided on the third interlayer dielectric 130.

A first wiring layer M1 may be provided in the fourth interlayer dielectric 140. The first wiring layer M1 may include wordline connection patterns WLC, gate connection patterns GCP (GCP1 and GCP2), a first sub-bitline BLa, a second sub-bitline BL_{b}, a first sub-complementary bitline BL'ₐ, a second sub-complementary bitline BL'_{b}, a power supply line Vdd, and a ground line Vss. At least a portion of the wirings of the second wiring layer M2 may extend in the second direction D2. For example, the first sub-bitline BLₐ, the second sub-bitline BL_{b}, the first sub-complementary bitline BL'ₐ, the second sub-complementary bitline BL'_{b}, and the power supply line Vdd may extend in the second direction D2.

The gate connection patterns GCP may be provided in the strap element region. The gate connection patterns may include first and second gate connection patterns GCP1 and GCP2 provided at locations overlapping gates of the first and second transistors T1 and T2 in the strap element SC.

The wordline connection patterns WLC, the gate connection patterns GCP, the first sub-bitline BLₐ, the second sub-bitline BL_{b}, the first sub-complementary bitline BL'a, the second sub-complementary bitline BL'_{b}, the power supply line Vdd, and the ground line Vss may be connected to the active contacts CA and the corresponding one of the first to fourth gate electrodes GE1, GE2, GE3, and GE4 and the first and second strap cell gate electrodes G1 and G2 through the active via VA and/or the gate contact CB provided in the third interlayer dielectric 130. For example, the wordline connection patterns WLC may be connected to the first gate electrode GE1 and the fourth gate electrode GE4 through the corresponding gate contacts CB. The first and second gate connection patterns GCP1 and GCP2 may be respectively connected to the first and second strap cell gate electrodes G1 and G2 through the corresponding gate contacts CB. The ground line Vss and the power supply line Vdd may be respectively connected to the active contacts CA through the corresponding active vias VA.

A fourth interlayer dielectric 150 and a sixth interlayer dielectric 160 may be sequentially provided on the fourth interlayer dielectric 140.

First vias V1 may be provided in the fourth interlayer dielectric 150. The first vias V1 may include wordline connection vias provided in the memory cell regions, strap line connection vias provided in the strap element region, and bitline connection vias. The strap line connection vias may include first and second strap line connection vias C1 and C2 provided on the first and second gate connection patterns GCP1 and GCP2. The bitline connection vias may include a first bitline connection via VC1 provided on the first sub-bitline BLₐ and a first complementary bitline connection via VC2 provided on the first sub-complementary bitline BL'ₐ.

A second wiring layer M2 may be provided in the sixth interlayer dielectric 160. The second wiring layer M2 may include wordlines, a strap cell control line SCL, and bitline connection patterns BCP (BCP1 and BCP2). At least a portion of the wirings of the second wiring layer M2 may extend in the first direction D1. For example, the wordlines and the strap cell control line SCL may extend in the first direction D1.

The bitline connection patterns BCP may be provided in the strap element region. The bitline connection patterns BCP may include a first bitline connection pattern BCP1 and a second bitline connection pattern BCP2, respectively overlapping the first sub-bitline BLₐ and the first sub-complementary bitline BL'ₐ.

The first bitline connection pattern BCP1 may be connected to the first sub-bitline BLₐ through the first bitline connection via VC1. The second bitline connection pattern BCP2 may be connected to the second sub-complementary bitline BL'_{b} through the first complementary bitline connection via VC2.

The strap cell control line SCL may be connected to the first and second gate connection patterns GCP1 and GCP2 through the first and second strap line connection vias C1 and C2.

A seventh interlayer dielectric 170 and an eighth interlayer dielectric 180 may be sequentially provided on the sixth interlayer dielectric 160.

Second vias V2 may be provided in the seventh interlayer dielectric 170. The second vias V2 may include a second bitline connection via VC3 and a second complementary bitline connection via VC4 provided on the first and second bitline connection patterns BCP1 and BCP2.

A third wiring layer M3 may be provided in the eighth interlayer dielectric 180. The third wiring layer M3 may include a third sub-bitline BL_{c} and a third sub-complementary bitline BL'_{c}. The third sub-bitline BL_{c} and the third sub-complementary bitline BL'_{c} may extend in the second direction D2.

The third sub-bitline BL_{c} may be connected to an underlying first bitline connection pattern BCP1 through the second bitline connection via VC3. The third sub-complementary bitline BL'_{c} may be connected to an underlying first complementary bitline connection pattern BCP2 through the second complementary bitline connection via VC4.

The first bitline connection via VC1, the first bitline connection pattern BCP1, and the second bitline connection via VC3 may form a first bitline connection structure BCT. The first bitline connection structure BCT may connect corresponding bitlines disposed in vertically different layers. The first sub-bitline BLₐ and the third sub-bitline BL_{c} may be connected through the first bitline connection structure BCT. In the same form, the first complementary bitline connection via VC2, the second bitline connection pattern BCP2, and the second complementary bitline connection via VC4 may form a second bitline connection structure BCT'. The second bitline connection structure BCT' may connect corresponding bitlines disposed in vertically different layers. The first sub-complementary bitline BL'ₐ and the third sub-complementary bitline BL'_{c} may be connected through the second bitline connection structure BCT'.

In one or more implementations, the first to third wiring layers M1, M2, and M3 may include various conductive materials. The first to third wiring layers M1, M2, and M3 may include at least one of a conductive metal nitride (for example, titanium nitride or tantalum nitride) and a metal material (for example, titanium, tantalum, tungsten, copper, or aluminum).

The first to eighth interlayer dielectrics 110, 120, 130, 140, 150, 160, 170, and 180 may include one or more dielectric layers. In one or more implementations, the first to eighth interlayer dielectrics 110, 120, 130, 140, 150, 160, 170, and 180 may independently include one or more layers of SiO₂, SiN, SiCN, SiOC, SiOCN, or other appropriate dielectric materials.

As described above, the strap element SC may be provided between the first memory cell array MCA1 and the second memory cell array MCA2 to easily pre-charge bitlines and complementary bitlines connected to the first memory cell array MCA1 and the second memory cell array MCA2. In addition, the pre-charge operation is performed using simple strap cells, so that an additional area increase for the strap cells may be significantly reduced.

The implementations illustrated in FIGS. 11A, 11B, and 12A-12C are related to the memory device having the wiring structure illustrated in FIG. 9A. However, the present inventive concepts are not limited thereto. For example, another implementation may be applied to a memory device having a wiring structure illustrated in FIG. 9B. In addition, other implementations may have a wiring structure. For example, the strap element may further include a component different from that of the above-described implementation.

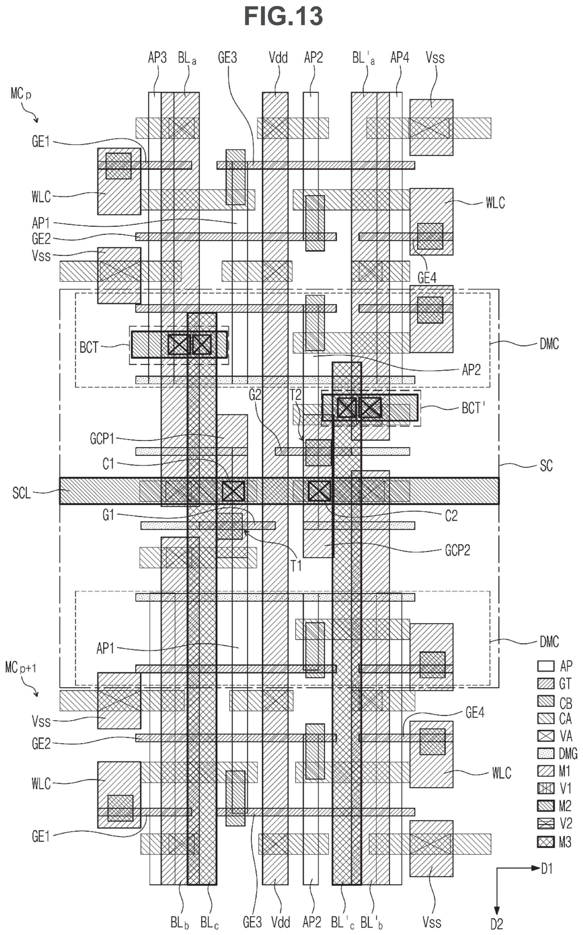

FIG. 13 is a plan view illustrating a memory device according to one or more implementation.

Hereinafter, the following implementations will mainly focus on the differences from the above-described implementations to avoid redundancy in the description.

Referring to FIG. 13, a strap element (strap circuit) SC may include a first strap cell S1, a second strap cell S2, and a dummy cell DMC. The memory device according to the present implementation is substantially the same as the memory device illustrated in FIG. 11A, except for the dummy cells DMC.

The dummy cells DMC may include at least one dummy transistor. The dummy cells DMC may be provided between the first and/or second strap cells S1 and S2 and a first memory cell MC1, or may be provided between the first and/or second strap cells S1 and/or S2 and a second memory cell MC2. Alternatively, the dummy cells DMC may be provided in both a region between the first and/or second strap cells S1 and/or S2 and the first memory cell MC1, and a region between the first and/or second strap cells S1 and/or S2 and the second memory cell MC2.

The dummy cells DMC may be a dummy transistor having a dummy gate electrode, or may be formed as a PMOS transistor and/or an NMOS transistor having an active gate electrode. However, even when the dummy cells DMC have an active gate electrode, the dummy cells DMC do not operate as a valid memory element.

As the strap element SC includes the dummy cells DMC, the strap element SC has a shape similar to a shape of the first and second memory cells MC1 and MC2. Thus, the strap element SC may be provided within an area similar to an area of the first and second memory cells MC1 and MC2. In addition, a gap between adjacent first memory cells MC1, a gap between an adjacent first memory cell MC1 and the strap element SC, and a gap between the strap element SC and the second memory cell MC2 may be maintained at substantially the same level. Accordingly, the regularity of the arrangement in the first memory cell array MCA1, the strap element SC, and the second memory cell array MCA2 may be maintained.

In one or more implementations, the strap element may be provided in various forms using at least one PMOS transistor, at least one NMOS transistor, a transmission gate, and/or a combination thereof. In the following implementations, strap elements implemented in various forms and wirings connected to the strap elements are merely exemplary. In other implementations, the memory device may have a layout different from the layouts disclosed in the following implementations, and the layers on which the respective components are disposed may also be different from the layers disclosed in the following implementations.

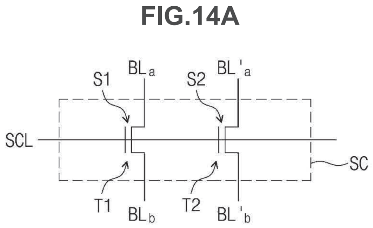

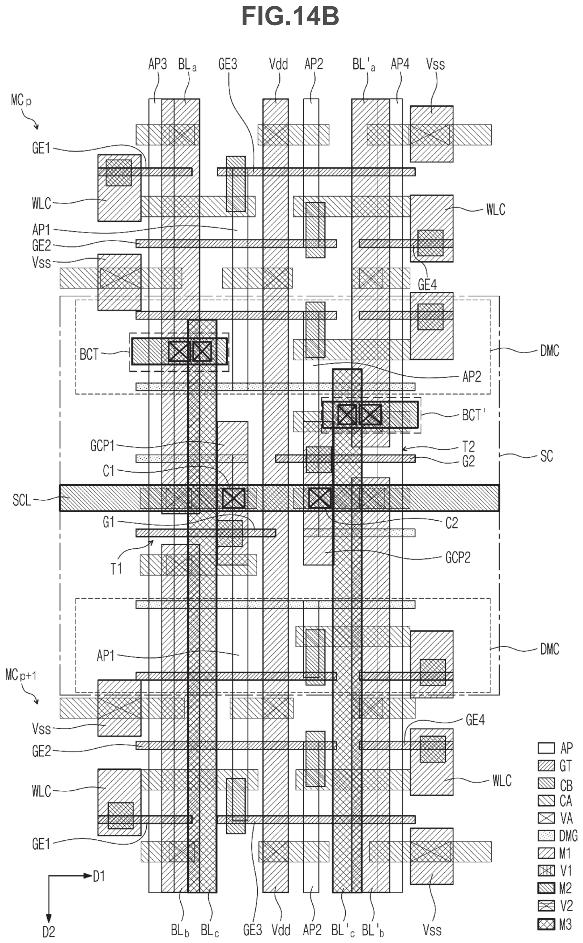

FIGS. 14A, 15A, 16A, 17A, 18A, 19A, 20A, 21A, 22A, 23A, 24A, 25A, 26A, 27A are circuit diagrams illustrating strap elements according to one or more implementations, and FIGS. 14B, 15B, 16B, 17B, 18B, 19B, 20B, 21B, 22B, 23B, 24B, 25B, 26B, 27B are plan views of memory devices including the strap elements illustrated in FIGS. 14A, 15A, 16A, 17A, 18A, 19A, 20A, 21A, 22A, 23A, 24A, 25A, 26A, 27A. In the following implementations, parts and reference numerals not described herein correspond to those of the above-describe implementations.

Referring to FIGS. 14A and 14B, a strap cell SC may include an NMOS transistor (hereinafter referred to as a first transistor T1) connected to a bitline as a first strap cell S1, and an NMOS transistor (hereinafter referred to as a second transistor T2) connected to a complementary bitline as a second strap cell S2. For example, a first sub-bitline BLₐ may be connected to a source of the first strap cell S1 and a second sub-bitline BL_{b} may be connected to a drain thereof, while a first complementary sub-bitline BL'ₐ may be connected to a source of the second strap cell S2 and a second complementary sub-bitline BL'_{b} may be connected to a drain thereof. Gates of the first strap cell S1 and the second strap cell S2 may be connected to a strap cell control line SCL. The first strap cell S1 and the second strap cell S2 may pre-charge/equalize the bitline and complementary bitline in response to a strap cell control signal.

In a strap element area, a first strap cell gate electrode G1 and a second strap cell gate electrode G2 may be provided to extend in a first direction D1 across a third active pattern AP3 and a fourth active pattern AP4. The third active pattern AP3 and the fourth active pattern AP4 may be spaced apart from each other in a second direction D2. The first strap cell gate electrode G1 may vertically overlap a third channel pattern, and the second strap cell gate electrode G2 may vertically overlap a fourth channel pattern.

The first strap cell gate electrode G1 on the third active pattern AP3 may be a gate of the first transistor T1 of the strap element SC, and the second strap cell gate electrode G2 on the fourth active pattern AP4 may be a gate of the second transistor T2 of the strap element SC.

In the strap element area, the first strap cell gate electrode G1 on the third active pattern AP3 and the source/drain patterns provided on opposite sides of the first strap cell gate electrode G1 may form the first strap cell S1, and the second strap cell gate electrode G2 on the fourth active pattern AP4 and the source/drain patterns provided on opposite sides of the second strap cell gate electrode G2 may form the second strap cell S2.

A first wiring layer M1 may be provided within a fourth interlayer dielectric 140. The first wiring layer M1 may include first and second gate connection patterns GCP1 and GCP2 provided at locations overlapping the gates of the first and second transistors T1 and T2 within the strap element SC. The first and second gate connection patterns GCP1 and GCP2 may be connected to the first and second strap cell gate electrodes G1 and G2 through gate contacts CB, respectively.

First vias V1 may be provided within a fourth interlayer dielectric 150. The first vias V1 may include strap line connection vias and bitline connection vias provided in the strap element area. The strap line connection vias may include a first strap line connection via C1 and a second strap line connection via C2 provided on the first and second gate connection patterns GCP1 and GCP2.

A second wiring layer M2 may be provided within a sixth interlayer dielectric 160. The second wiring layer M2 may include the strap cell control line SCL. The strap cell control line SCL may be connected to the first and second gate connection patterns GCP1 and GCP2 through the first and second strap line connection vias C1 and C2.

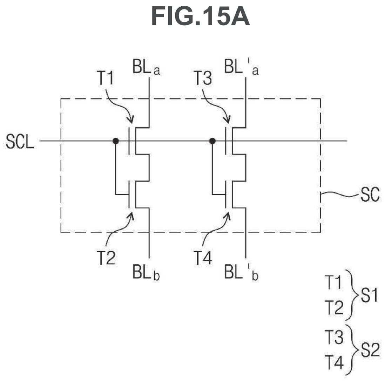

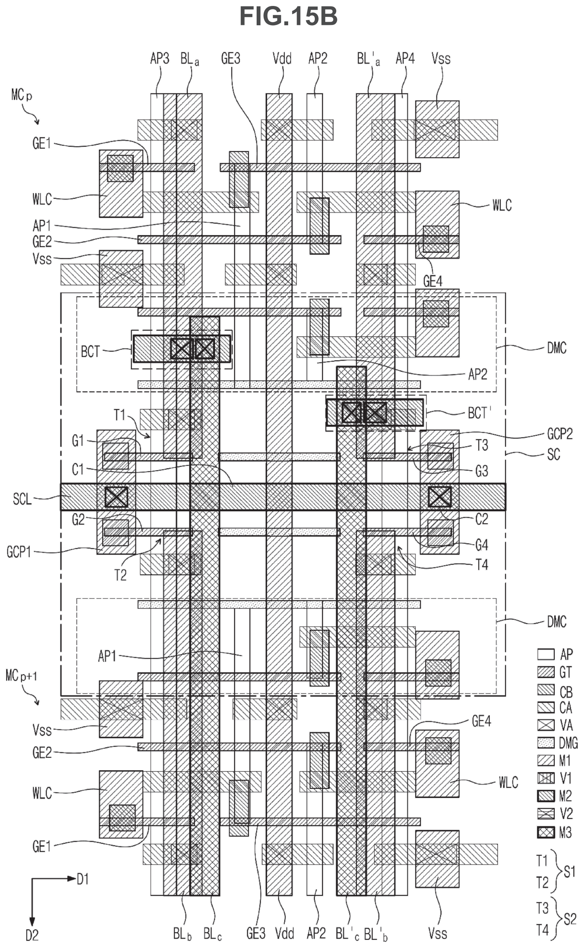

Referring to FIGS. 15A and 15B, the strap cell SC may include two NMOS transistors connected in series to a bitline as the first strap cell S1 and two NMOS transistors connected in series to a complementary bitline as the second strap cell S2. For example, two NMOS transistors may be connected between a first sub bitline BLₐ and a second sub bitline BL_{b} as a first transistor T1 and a second transistor T2, and two NMOS transistors may be connected between a first complementary sub bitline BL'ₐ and a second complementary sub bitline BL'_{b} as a third transistor T3 and a fourth transistor T4. The first and second transistors T1 and T2 may form the first strap cell S1, and the third and fourth transistors T3 and T4 may form the second strap cell S2. Gates of the first strap cell S1 and the second strap cell S2 may be connected to the strap cell control line SCL. The first strap cell S1 and the second strap cell S2 may pre-charge/equalize the bitline and the complementary bitline in response to a strap cell control signal.

In the strap element area, a first strap cell gate electrode G1 and a second strap cell gate electrode may extend in a first direction D1 across the third active pattern AP3. A third strap cell gate electrode G3 and a fourth strap cell gate electrode G4 may extend in the first direction D1 across the fourth active pattern AP4. The first strap cell gate electrode G1 and the third strap cell gate electrode G3 may be spaced apart from each other in the first direction D1. The second strap cell gate electrode and the fourth strap cell gate electrode G4 may also be spaced apart from each other in the first direction D1.

The first strap cell gate electrode G1 and the second strap cell gate electrode G2 may vertically overlap a third channel pattern, and the third strap cell gate electrode G3 and the fourth strap cell gate electrode G4 may vertically overlap a fourth channel pattern.

In the strap element area, the first strap cell gate electrode G1 on the third active pattern AP3 and the source/drain patterns provided on opposite sides of the first strap cell gate electrode G1 may form the first transistor T1, and the second strap cell gate electrode G2 on the third active pattern AP3 and the source/drain patterns provided on opposite sides of the third strap cell gate electrode G3 may form the second transistor T2. The first and second transistors T1 and T2 may form the first strap cell S1. In addition, the third strap cell gate electrode G3 on the fourth active pattern AP4 and the source/drain patterns provided on opposite sides of the third strap cell gate electrode G3 may form the third transistor T3, and the fourth strap cell gate electrode G4 on the fourth active pattern AP4 and the source/drain patterns provided on opposite sides of the fourth strap cell gate electrode G4 may form the fourth transistor T4. The third and fourth transistors T3 and T4 may form the second strap cell S2.

A first wiring layer M1 may be provided within a fourth interlayer dielectric 140. The first wiring layer M1 may include a first gate connection pattern GCP1 provided at a location overlapping gates of the first and second transistors T1 and T2 within the strap element SC, and a second gate connection pattern GCP2 provided at a location overlapping gates of the third and fourth transistors T3 and T4. The first gate connection pattern GCP1 may be connected to the first and second strap cell gate electrodes G1 and G2 through gate contacts CB, and the second gate connection pattern GCP2 may be connected to the third and fourth strap cell gate electrodes G3 and G4 through gate contacts CB.

First vias V1 may be provided in a fourth interlayer dielectric 150. The first vias V1 may include strap line connection vias provided in a strap element region. The strap line connection vias may include a first strap line connection via C1 and a second strap line connection via C2, respectively provided on first and second gate connection patterns GCP1 and GCP2.

A second wiring layer M2 may be provided in a sixth interlayer dielectric 160. The second wiring layer M2 may include a strap cell control line SCL. The strap cell control line SCL may be connected to the first and second gate connection patterns GCP1 and GCP2 through the first and second strap line connection vias C1 and C2.

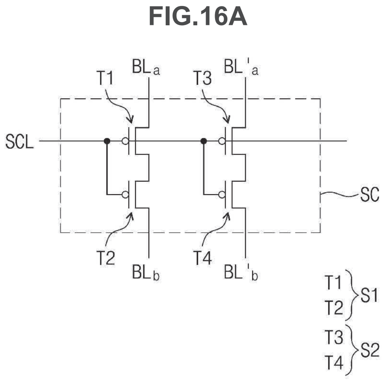

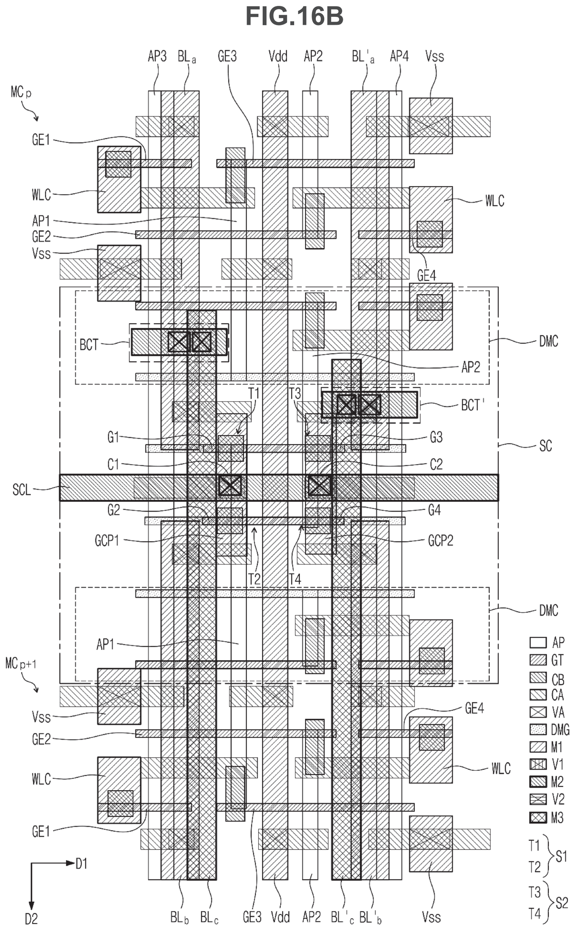

Referring to FIGS. 16A and 16B, a strap element (strap circuit) SC may include two PMOS transistors connected in series to a bitline as a first strap cell S1, and two PMOS transistors connected in series to a complementary bitline as a second strap cell S2. For example, two PMOS transistors as first and second transistors T1 and T2 may be connected between a first sub-bitline BLₐ and a second sub-bitline BL_{b}, and two PMOS transistors as third and fourth transistors T3 and T4 may be connected between a first sub-complementary bitline BL'ₐ and a second sub-complementary bitline BL'_{b}. The first and second transistors T1 and T2 form a first strap cell S1, and the third and fourth transistors T3 and T4 may form a second strap cell S2. Gates of the first strap cell S1 and the second strap cell S2 may be connected to a strap cell control line SCL. The first strap cell S1 and the second strap cell S2 may pre-charge/equalize the bitline and the complementary bitline in response to a strap cell control signal.

In the strap element region, a first strap cell gate electrode G1 and a second strap cell gate electrode may extend in a first direction D1 crossing a first active pattern AP1. A third strap cell gate electrode G3 and a fourth strap cell gate electrode G4 may extend in the first direction D1 crossing a second active pattern AP2. The first strap cell gate electrode G1 and the third strap cell gate electrode G3 may be integrally formed and may extend in the first direction D1. The second strap cell gate electrode and the fourth strap cell gate electrode G4 may also be integrally formed and may extend in the first direction D1.

The first strap cell gate electrode G1 and a second strap cell gate electrode G2 may vertically overlap a first channel pattern, and the third strap cell gate electrode G3 and the fourth strap cell gate electrode G4 may vertically overlap a second channel pattern.

In the strap element region, the first strap cell gate electrode G1 on the first active pattern AP1 and source/drain patterns provided on opposite sides of the first strap cell gate electrode G1 may form a first transistor T1, and the second strap cell gate electrode G2 on the first active pattern AP1 and source/drain patterns provided on opposite sides of the second strap cell gate electrode G2 may form a second transistor T2. The first and second transistors T1 and T2 may form a first strap cell S1. In addition, the third strap cell gate electrode G3 on the second active pattern AP2 and source/drain patterns provided on opposite sides of the third strap cell gate electrode G3 may form a third transistor T3, and the fourth strap cell gate electrode G4 on the second active pattern AP2 and source/drain patterns provided on opposite sides of the fourth strap cell gate electrode G4 may form a fourth transistor T4. The third and fourth transistors T3 and T4 may form a second strap cell S2.

A first wiring layer M1 may be provided in a fourth interlayer dielectric 140. The first wiring layer M1 may include a first gate connection pattern GCP1 provided at a location overlapping gates of the first and second transistors T1 and T2 in the strap element SC and a second gate connection pattern GCP2 provided at a location overlapping gates of the third and fourth transistors T3 and T4. The first gate connection pattern GCP1 may be connected to the first and second strap cell gate electrodes G1 and G2 through gate contacts CB, and the second gate connection pattern GCP2 may be connected to the third and fourth strap cell gate electrodes G3 and G4 through gate contacts CB.

First vias V1 may be provided in a fourth interlayer dielectric 150. The first vias V1 may include strap line connection vias provided in a strap element region. The strap line connection vias may include a first strap line connection via C1 and a second strap line connection via C2 provided on the first and second gate connection patterns GCP1 and GCP2, respectively.

A second wiring layer M2 may be provided in a sixth interlayer dielectric 160. The second wiring layer M2 may include a strap cell control line SCL. The strap cell control line SCL may be connected to the first and second gate connection patterns GCP1 and GCP2 through the first and second strap line connection vias C1 and C2.

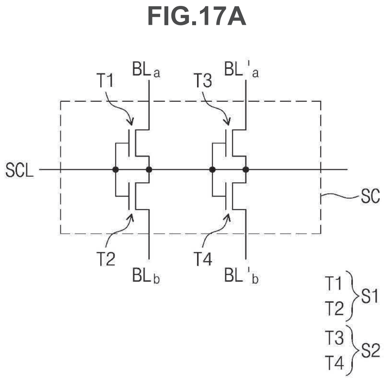

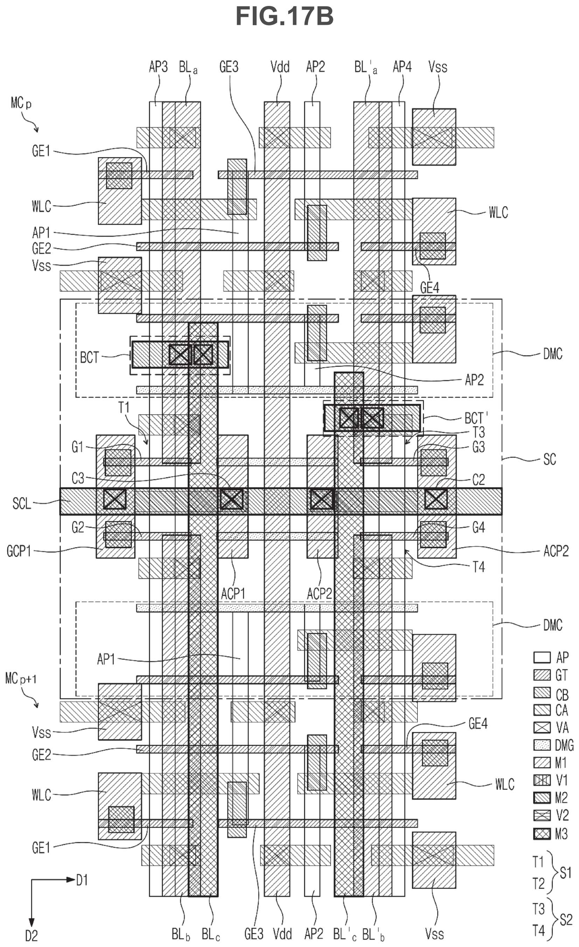

Referring to FIGS. 17A and 17B, the strap element SC may include two NMOS transistors connected in series to a bitline as a first strap cell S1, and two NMOS transistors connected in series to a complementary bitline as a second strap cell S2. For example, two NMOS transistors, as first and second transistors T1 and T2, may be connected between a first sub-bitline BLa and a second sub-bitline BLb, and two NMOS transistors, as third and fourth transistors T3 and T4, may be connected between a first sub-complementary bitline BL'ₐ and a second sub-complementary bitline BL'_{b}. The first and second transistors T1 and T2 may form a first strap cell S1, and the third and fourth transistors T3 and T4 may form a second strap cell S2. A strap cell control line SCL may be connected between a gate of the first strap cell S1, a gate of the second strap cell S2, a drain of the first strap cell S1, and a source of the second strap cell S2. The first strap cell S1 and the second strap cell S2 may pre-charge/equalize the bitline and the complementary bitline in response to a strap cell control signal.

In the strap element region, the first strap cell gate electrode G1 and the second strap cell gate electrode may extend in the first direction D1 crossing a third active pattern AP3. The third strap cell gate electrode G3 and the fourth strap cell gate electrode G4 may extend in the first direction D1 crossing a fourth active pattern AP4. The first strap cell gate electrode G1 and the third strap cell gate electrode G3 may be spaced apart from each other along the first direction D1. The second strap cell gate electrode and the fourth strap cell gate electrode G4 may also be spaced apart from each other along the first direction D1.

The first strap cell gate electrode G1 and the second strap cell gate electrode G2 may vertically overlap a third channel pattern, and the third strap cell gate electrode G3 and the fourth strap cell gate electrode G4 may vertically overlap a fourth channel pattern.

In the strap element region, the first strap cell gate electrode G1 on the third active pattern AP3 and source/drain patterns provided on opposite sides of the first strap cell gate electrode G1 may form a first transistor T1, and the second strap cell gate electrode G2 on the third active pattern AP3 and source/drain patterns provided on opposite sides of the third strap cell gate electrode G3 may form a second transistor T2. The first and second transistors T1 and T2 may form a first strap cell S1. In addition, the third strap cell gate electrode G3 on the fourth active pattern AP4 and source/drain patterns provided on opposite sides of the third strap cell gate electrode G3 may form a third transistor T3, and the fourth strap cell gate electrode G4 on the fourth active pattern AP4 and source/drain patterns provided on opposite sides of the fourth strap cell gate electrode G4 may form a fourth transistor T4. The third and fourth transistors T3 and T4 form a second strap cell S2.

A first active contact CA may be provided on the third active pattern AP3 between the first and second transistors T1 and T2. A second active contact CA may be provided between the third and fourth transistors T3 and T4. The first and second active contacts CA may extend in the first direction D1.

A first wiring layer M1 may be provided in a fourth interlayer dielectric 140. The first wiring layer M1 may include a first gate connection pattern GCP1 provided at a location overlapping gates of the first and second transistors T1 and T2 in the strap element SC and a second gate connection pattern GCP2 provided at a location overlapping gates of the third and fourth transistors T3 and T4. The first wiring layer M1 may also include a first active connection pattern connected to the first active contact CA and a second active connection pattern connected to the second active contact CA in the strap element SC.

The first gate connection pattern GCP1 may be connected to the first and second strap cell gate electrodes G1 and G2 through gate contacts CB, and the second gate connection pattern GCP2 may be connected to the third and fourth strap cell gate electrodes G3 and G4 through gate contacts CB. The first active connection pattern and the second active connection pattern may be connected to the first active contact CA through active vias VA, respectively.

First vias V1 may be provided in a fourth interlayer dielectric 150. The first vias V1 may include strap line connection vias provided in a strap element region. The strap line connection vias may include first and second strap line connection vias C1 and C2, respectively provided on the first and second gate connection patterns GCP1 and GCP2, and third strap line vias C3 provided on the first and second active connection patterns.

A second wiring layer M2 may be provided in a sixth interlayer dielectric 160. The second wiring layer M2 may include a strap cell control line SCL. The strap cell control line SCL may be connected to the first and second gate connection patterns GCP1 and GCP2 and the first and second active connection patterns through the first to fourth strap line connection vias C1, C2, C3, and C4.

The connection relationships of wirings other than the strap element SC, for example, the bitline and the complementary bitline, are substantially the same as the above-described implementations, so that a description thereof is omitted. For example, the first sub-bitline BLₐ and the third sub-bitline BL_{c} may be connected through a first bitline connection structure BCT, and the first sub-complementary bitline BL'ₐ and the third sub-complementary bitline BL'_{c} may be connected through a second bitline connection structure BCT'.

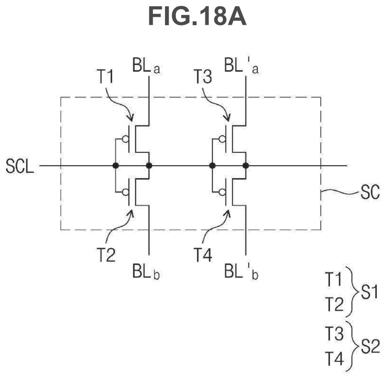

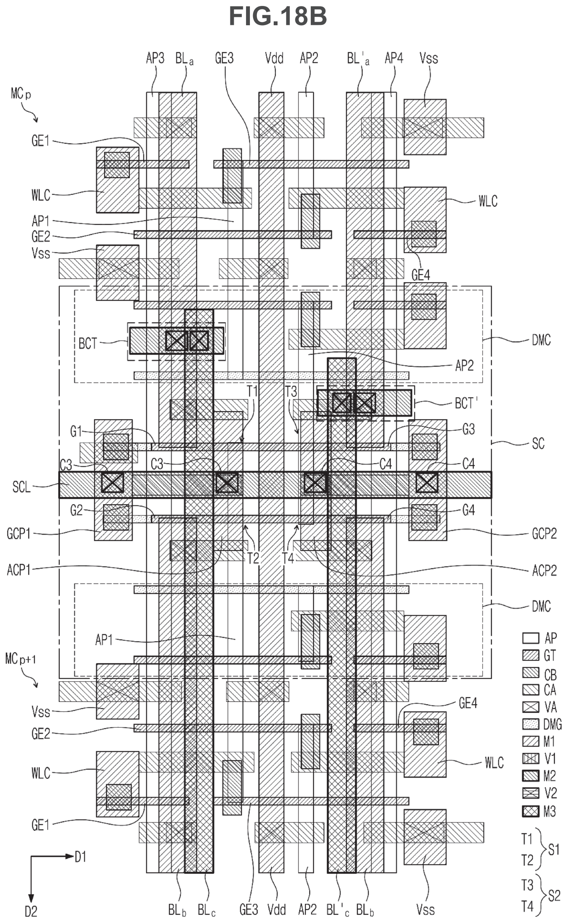

Referring to FIGS. 18A and 18B, a strap element (strap circuit) SC may include two PMOS transistors connected in series to a bitline as a first strap cell S1 and two PMOS transistors connected in series to a complementary bitline as a second strap cell S2. For example, two PMOS transistors, as first and second transistors T1 and T2, may be connected between a first sub-bitline BLₐ and a second sub-bitline BL_{b}, and two PMOS transistors, as third and fourth transistors T3 and T4, may be connected between a first sub-complementary bitline BL'ₐ and a second sub-complementary bitline BL'_{b}. The first and second transistors T1 and T2 may form a first strap cell S1, and the third and fourth transistors T3 and T4 may form a second strap cell S2. A strap cell control line SCL may be connected between a gate of the first strap cell S1, a gate of the second strap cell S2, a drain of the first strap cell S1, and a source of the second strap cell S2. The first strap cell S1 and the second strap cell S2 may pre-charge/equalize the bitline and the complementary bitline in response to a strap cell control signal.

In a strap element region, a first strap cell gate electrode G1 and a second strap cell gate electrode may extend in a first direction D1 crossing a first active pattern. A third strap cell gate electrode G3 and a fourth strap cell gate electrode G4 may extend in the first direction D1 crossing a second active pattern AP2. The first strap cell gate electrode G1 and the third strap cell gate electrode G3 may be provided integrally and may extend in the first direction D1. The second strap cell gate electrode and the fourth strap cell gate electrode G4 may also be provided integrally and may extend in the first direction D1.

The first strap cell gate electrode G1 and a second strap cell gate electrode G2 may vertically overlap a first channel pattern, and the third strap cell gate electrode G3 and the fourth strap cell gate electrode G4 may vertically overlap a second channel pattern.

In the strap element region, the first strap cell gate electrode G1 on the first active pattern AP1 and source/drain patterns provided on opposite sides of the first strap cell gate electrode G1 may form a first transistor T1, and the second strap cell gate electrode G2 on the first active pattern AP1 and source/drain patterns provided on opposite sides of the second strap cell gate electrode G2 may form a second transistor T2. The first and second transistors T1 and T2 may form a first strap cell S1. In addition, the third strap cell gate electrode G3 on the second active pattern AP2 and source/drain patterns provided on opposite sides of the third strap cell gate electrode G3 may form a third transistor T3, and the fourth strap cell gate electrode G4 on the second active pattern AP2 and source/drain patterns provided on opposite sides of the fourth strap cell gate electrode G4 may form a fourth transistor T4. The third and fourth transistors T3 and T4 may form a second strap cell S2.

A first active contact CA may be provided on a third active pattern AP3 between the first and second transistors T1 and T2. A second active contact CA may be provided between the third and fourth transistors T3 and T4. The first and second active contacts CA may extend in the first direction D1.

A first wiring layer M1 may be provided in a fourth interlayer dielectric 140. The first wiring layer M1 may include a first gate connection pattern GCP1 provided at a location overlapping gates of the first and second transistors T1 and T2 in the strap element SC and a second gate connection pattern GCP2 provided at a location overlapping gates of the third and fourth transistors T3 and T4. The first wiring layer M1 may also include a first active connection pattern connected to the first active contact CA and a second active connection pattern connected to the second active contact CA in the strap element SC.

The first gate connection pattern GCP1 may be connected to the first and second strap cell gate electrodes G1 and G2 through gate contacts CB, and the second gate connection pattern GCP2 may be connected to the third and fourth strap cell gate electrodes G3 and G4 through gate contacts CB. The first and second active connection patterns may be respectively connected to the first and second active contacts CA through active vias VA.

First vias V1 may be provided in a fourth interlayer dielectric 150. The first vias V1 may include strap line connection vias provided in a strap element region. The strap line connection vias may include first and second strap line connection vias C1 and C2, respectively provided on the first and second gate connection patterns GCP1 and GCP2, and third strap line vias C3 provided on the first and second active connection patterns.

A second wiring layer M2 may be provided in a sixth interlayer dielectric 160. The second wiring layer M2 may include a strap cell control line SCL. The strap cell control line SCL may be connected to the first and second gate connection patterns GCP1 and GCP2 and the first and second active connection patterns through the first to fourth strap line connection vias C1, C2, C3, and C4.

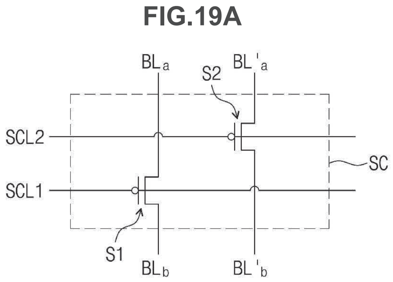

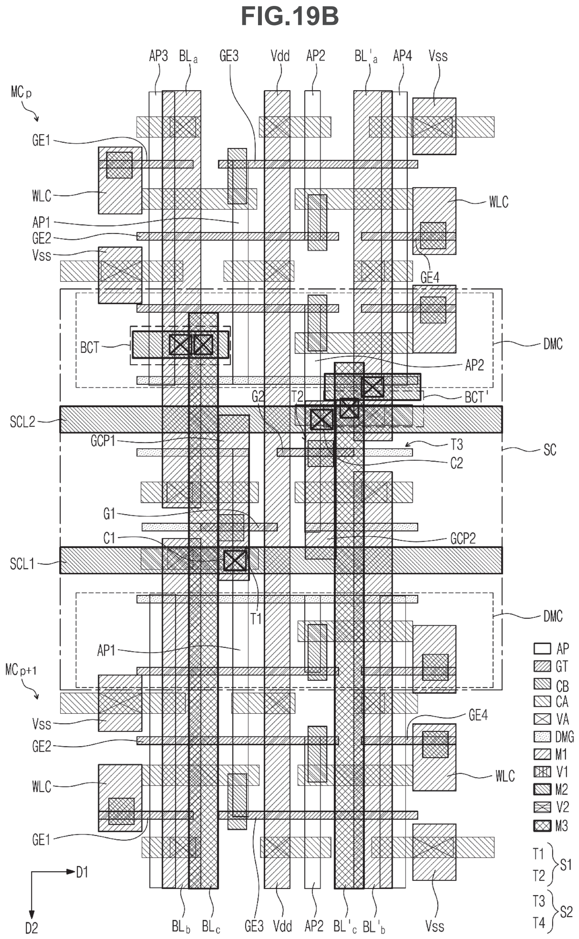

Referring to FIGS. 19A and 19B, a strap element (strap circuit) SC may include a PMOS transistor connected to a bitline as a first strap cell S1, and a PMOS transistor connected to a complementary bitline as a second strap cell S2. For example, a first sub-bitline BLₐ may be connected to a source of the first strap cell S1 and a second sub-bitline BL_{b} may be connected to a drain of the first strap cell S1, and a first complementary sub-bitline BL'ₐ may be connected to a source of the second strap cell S2 and a second complementary sub-bitline BL'_{b} may be connected to a drain of the second strap cell S2. A gate of the first strap cell S1 may be connected to a first strap cell control line SCL1, and a gate of the second strap cell S2 may be connected to a second strap cell control line SCL2. The first strap cell S1 may pre-charge/equalize the bitline in response to a first strap cell (S1) control signal, and the second strap cell S2 may pre-charge/equalize the complementary bitline in response to a second strap cell (S2) control signal.

In the strap element area, a first strap cell gate electrode G1 and a second strap cell gate electrode G2 extending in a first direction D1 across a first active pattern AP1 and a second active pattern AP2 may be provided. The first active pattern AP1 and the second active pattern AP2 may be spaced apart from each other in a second direction D2. The first strap cell gate electrode G1 may vertically overlap a first channel pattern, and the second strap cell gate electrode G2 may vertically overlap a second channel pattern.

The first strap cell gate electrode G1 on the second active pattern AP2 may be a gate of a first transistor T1 of the strap element SC, and the second strap cell gate electrode G2 on the second active pattern AP2 may be a gate of a second transistor T2 of the strap element SC.

In the strap element area, the first strap cell gate electrode G1 on the first active pattern AP1 and the source/drain patterns provided on opposite sides of the first strap cell gate electrode G1 may form the first strap cell S1, and the second strap cell gate electrode G2 on the second active pattern AP2 and the source/drain patterns provided on opposite sides of the second strap cell gate electrode G2 may form the second strap cell S2.

A first wiring layer M1 may be provided within a fourth interlayer dielectric 140. The first wiring layer M1 may include first and second gate connection patterns GCP1 and GCP2 provided at locations overlapping the gates of the first and second transistors T1 and T2 within the strap element SC. The first and second gate connection patterns GCP1 and GCP2 may each be connected to the first and second strap cell gate electrodes G and G2 through gate contacts CB, respectively.

First vias V1 may be provided within a fourth interlayer dielectric 150. The first vias V1 may include a first strap line connection via C1 and a second strap line connection via C2 provided on the first and second gate connection patterns GCP1 and GCP2.

A second wiring layer M2 may be provided within a sixth interlayer dielectric 160. The second wiring layer M2 may include the first and second strap cell control lines SCL1 and SCL2. The first and second strap cell control lines SCL1 and SCL2 may extend in a first direction D1 and may be spaced apart from each other in a second direction D2.

The first strap cell control line SCL1 may be connected to the first gate connection pattern GCP1 through the first strap line connection vias C1. The second strap cell control line SCL2 may be connected to the second gate connection pattern GCP2 through the second strap line connection vias C2.

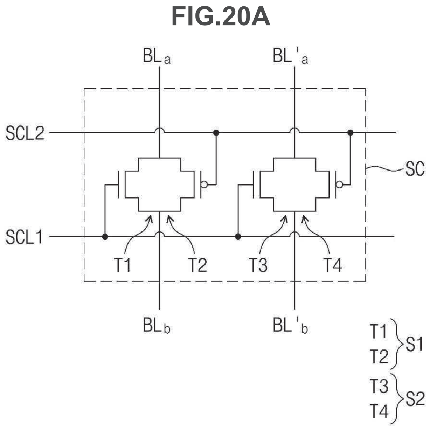

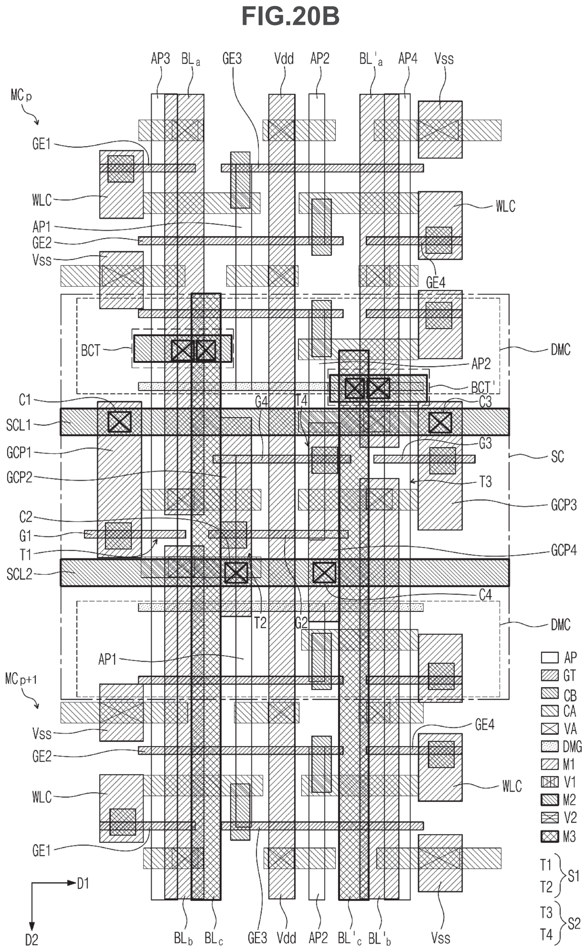

Referring to FIGS. 20A and 20B, the strap element SC may include a first strap cell S1 connected to a bitline and a second strap cell S2 connected to a complementary bitline. The first strap cell S1 may be a transmission gate in which a first transistor T1, which is an NMOS transistor, and a second transistor T2, which is a PMOS transistor, are connected in parallel. The second strap cell S2 may be a transmission gate in which a third transistor T3, which is an NMOS transistor, and a fourth transistor T4, which is a PMOS transistor, are connected in parallel. Gates of the first and third transistors T1 and T3 may be connected to a first strap cell control line SCL1, and gates of the second and fourth transistors T2 and T4 may be connected to a second strap cell control line SCL2.

In the strap element area, a first strap cell gate electrode G1 may cross a third active pattern AP3, a second strap cell gate electrode G2 may cross a first active pattern AP1, a third strap cell gate electrode G3 may cross a second active pattern AP2, and a fourth strap cell gate electrode G4 may cross a fourth active pattern AP4. The first strap cell gate electrode G1 and the second strap cell gate electrode G2 may be aligned side by side in the first direction D1. The third strap cell gate electrode G3 and the fourth strap cell gate electrode G4 may be aligned side by side in the first direction D1.

The first strap cell gate electrode G1 may vertically overlap a third channel pattern, the second strap cell gate electrode G2 may vertically overlap a first channel pattern, the third strap cell gate electrode G3 may vertically overlap a second channel pattern, and the fourth strap cell gate electrode G4 may vertically overlap a fourth channel pattern.

In the strap element area, the first strap cell gate electrode G1 on the third active pattern AP3 may be a gate of the first transistor T1 of the strap element SC, the second strap cell gate electrode G2 on the first active pattern AP1 may be a gate of the second transistor T2 of the strap element SC, the third strap cell gate electrode G3 on the second active pattern AP2 may be a gate of the third transistor T3 of the strap element SC, and the fourth strap cell gate electrode G4 on the fourth active pattern AP4 may be a gate of the fourth transistor T4 of the strap element SC.

In the strap element area, the first strap cell gate electrode G1 on the third active pattern AP3 and the source/drain patterns provided on opposite sides of the first strap cell gate electrode G1 may form the first transistor T1. The second strap cell gate electrode G2 on the first active pattern AP1 and the source/drain patterns provided on opposite sides of the first strap cell gate electrode G1 may form The second transistor T2. The first and second transistors T1 and T2 form the first strap cell S1. In addition, the third strap cell gate electrode G3 on the fourth active pattern AP4 and the source/drain patterns provided on opposite sides of the third strap cell gate electrode G3 may form the third transistor T3. The fourth strap cell gate electrode G4 on the third active pattern AP3 and the source/drain patterns provided on opposite sides of the fourth strap cell gate electrode G4 may form the fourth transistor T4. The third and fourth transistors T3 and T4 form the second strap cell S2.

A first wiring layer M1 may be provided within a fourth interlayer dielectric 140. The first wiring layer M1 may include first to fourth gate connection patterns GCP1, GCP2, GCP3, and GCP4 provided at positions overlapping the gates of the first to fourth transistors T1, T2, T3, and T4 within the strap element SC. The first to fourth gate connection patterns GCP1, GCP2, GCP3, and GCP4 may be connected to the first to fourth strap cell gate electrodes G1, G2, G3, and G4 through gate contacts CB, respectively.

First vias V1 may be provided within a fourth interlayer dielectric 150. The first vias V1 may include strap line connection vias provided in the strap element area. The strap line connection vias may include first to fourth strap line connection vias C1, C2, C3, and C4 provided on the first to fourth gate connection patterns GCP1, GCP2, GCP3, and GCP4, respectively.

A second wiring layer M2 may be provided within a sixth interlayer dielectric 160. The second wiring layer M2 may include the first and second strap cell control lines SCL1 and SCL2. The first strap cell control line SCL1 may be connected to the first gate connection patterns GCP1 through the first strap line connection via C1. Similarly, the second strap cell control line SCL2 may be connected to the second gate connection pattern GCP1 through the second strap line connection via C2.

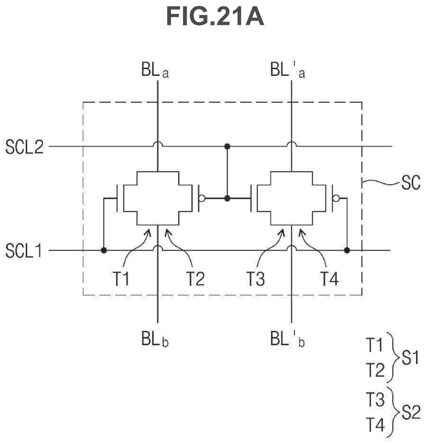

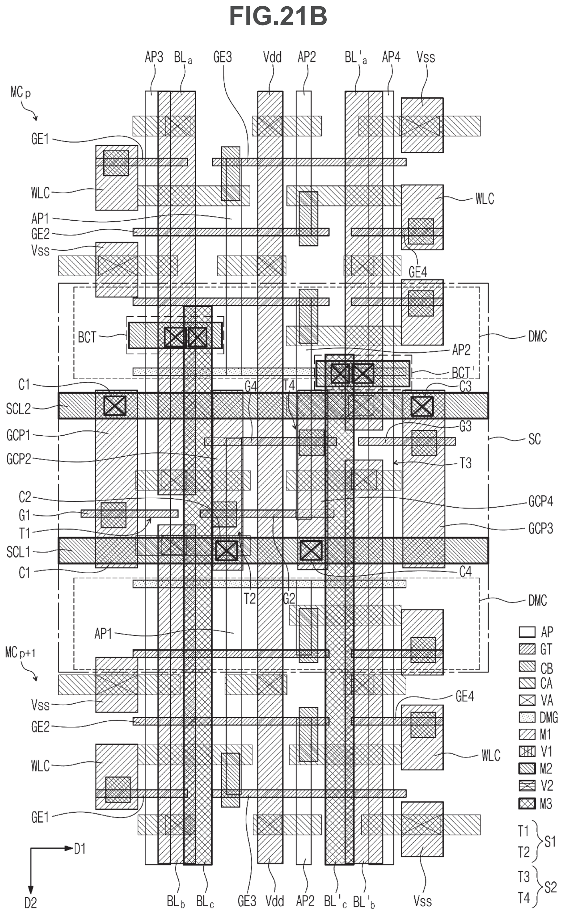

Referring to FIGS. 21A and 21B, a strap element (strap circuit) SC may include a first strap cell S1 connected to a bitline and a second strap cell S2 connected to a complementary bitline. The first strap cell S1 may be a transmission gate in which a first transistor T1, which is an NMOS transistor, and a second transistor T2, which is a PMOS transistor, are connected in parallel. The second strap cell S2 may be a transmission gate in which a third transistor T3, which is an NMOS transistor, and a fourth transistor T4, which is a PMOS transistor, are connected in parallel. Gates of the first and fourth transistors T4 may be connected to a first strap cell (S1) control line, and gates of the second transistor T2 and the third transistor T3 may be connected to a second strap cell (S2) control line.

In the strap element area, a first strap cell gate electrode G1 may cross a third active pattern AP3, a second strap cell gate electrode G2 may cross a first active pattern AP1, a third strap cell gate electrode G3 may cross a second active pattern AP2, and a fourth strap cell gate electrode G4 may cross a fourth active pattern AP4. The first strap cell gate electrode G1 and the second strap cell gate electrode G2 may be aligned side by side in a first direction D1. The third strap cell gate electrode G3 and the fourth strap cell gate electrode G4 may be aligned side by side in the first direction D1.

The first strap cell gate electrode G1 may vertically overlap a third channel pattern, the second strap cell gate electrode G2 may vertically overlap a first channel pattern, the third strap cell gate electrode G3 may vertically overlap a second channel pattern, and the fourth strap cell gate electrode G4 may vertically overlap a fourth channel pattern.

In the strap element area, the first strap cell gate electrode G1 on the third active pattern AP3 may be a gate of the first transistor T1 of the strap element SC, the second strap cell gate electrode G2 on the first active pattern AP1 may be a gate of the second transistor T2 of the strap element SC, the third strap cell gate electrode G3 on the second active pattern AP2 may be a gate of the third transistor T3 of the strap element SC, and the fourth strap cell gate electrode G4 on the fourth active pattern AP4 may be a gate of the fourth transistor T4 of the strap element SC.

In the strap element area, the first strap cell gate electrode G1 on the third active pattern AP3 and the source/drain patterns provided on opposite sides of the first strap cell gate electrode G1 may form the first transistor T1. The second strap cell gate electrode G2 on the first active pattern AP1 and the source/drain patterns provided on opposite sides of the first strap cell gate electrode G1 may form the second transistor T2. The first and second transistors T1 and T2 may form the first strap cell S1. In addition, the third strap cell gate electrode G3 on the fourth active pattern AP4 and the source/drain patterns provided on opposite sides of the third strap cell gate electrode G3 may form the third transistor T3. The fourth strap cell gate electrode G4 on the third active pattern AP3 and the source/drain patterns provided on opposite sides of the fourth strap cell gate electrode G4 may form the fourth transistor T4. The third and fourth transistors T3 and T4 may form the second strap cell S2.

A first wiring layer M1 may be provided within a fourth interlayer dielectric 140. The first wiring layer M1 may include first to fourth gate connection patterns GCP1, GCP2, GCP3, and GCP4 provided at positions overlapping the gates of the first to fourth transistors T1, T2, T3, and T4 within the strap element SC. The first to fourth gate connection patterns GCP1, GCP2, GCP3, and GCP4 may be connected to the first to fourth strap cell gate electrodes G1, G2, G3, and G4 through gate contacts CB, respectively.

First vias V1 may be provided within a fourth interlayer dielectric 150. The first vias V1 may include strap line connection vias provided in the strap element area. The strap line connection vias may include first to fourth strap line connection vias C1, C2, C3, and C4, respectively provided on the first to fourth gate connection patterns GCP1, GCP2, GCP3, and GCP4.

A second wiring layer M2 may be provided within a sixth interlayer dielectric 160. The second wiring layer M2 may include the first and second strap cell control lines SCL1 and SCL2. The first strap cell control line SCL1 may be connected to the first and fourth gate connection patterns GCP1, GCP2, GCP3, and GCP4 through the first and fourth strap line connection vias C4. The second strap cell control line SCL2 may be connected to the second and third gate connection patterns GCP2 and GCP3 through the second and third strap line connection vias C3.

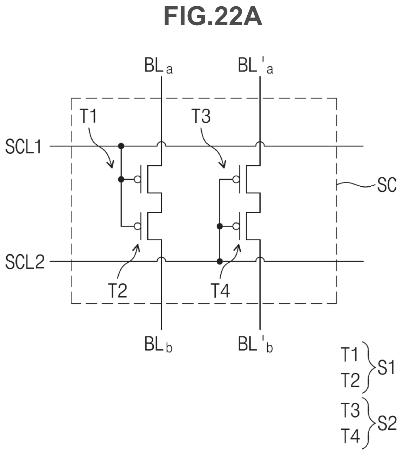

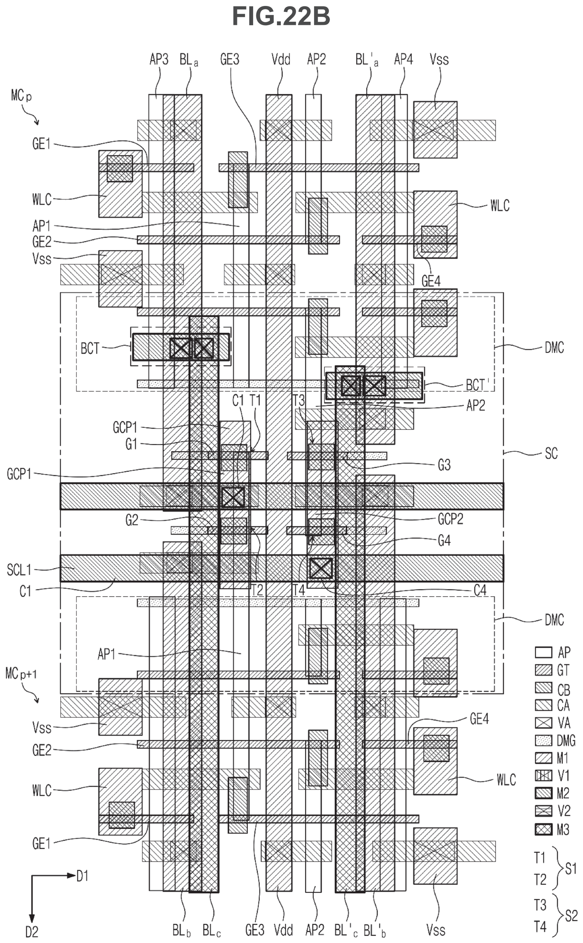

Referring to FIGS. 22A and 22B, a strap element (strap circuit) SC may include two PMOS transistors connected in series to a bitline, as a first strap cell S1, and two PMOS transistors connected in series to a complementary bitline, as a second strap cell S2. For example, two PMOS transistors may be connected between a first sub-bitline BLₐ and a second sub-bitline BL_{b} as a first transistor T1 and a second transistor T2. The two PMOS transistors are connected between a first complementary sub-bitline BL'ₐ and a second complementary sub-bitline BL'_{b} as a third transistor T3 and a fourth transistor T4. The first and second transistors T1 and T2 may form the first strap cell S1, and the third and fourth transistors T3 and T4 may form the second strap cell S2. A gate of the first strap cell S1 may be connected to a first strap cell control line SCL1, and a gate of the second strap cell S2 may be connected to a second strap cell control line SCL2. The first strap cell S1 and the second strap cell S2 may pre-charge/equalize the bitline and the complementary bitline in response to a first strap cell (S1) control signal and a second strap cell (S2) control signal, respectively.

In the strap element area, a first strap cell gate electrode G1 and a second strap cell gate electrode may extend in a first direction D1 across a first active pattern AP1. A third strap cell gate electrode G3 and a fourth strap cell gate electrode G4 may extend in the first direction D1 across a second active pattern AP2. The first strap cell gate electrode G1 and the third strap cell gate electrode G3 are integrally formed and may extend along the first direction D1. The second strap cell gate electrode and the fourth strap cell gate electrode G4 are also integrally formed and may extend in the first direction D1.

The first strap cell gate electrode G1 and the second strap cell gate electrode G2 may vertically overlap a first channel pattern, and the third strap cell gate electrode G3 and the fourth strap cell gate electrode G4 may vertically overlap a second channel pattern.

In the strap element area, the first strap cell gate electrode G1 on the first active pattern AP1 and the source/drain patterns provided on opposite sides of the first strap cell gate electrode G1 may form the first transistor T1. The second strap cell gate electrode G2 on the first active pattern AP1 and the source/drain patterns provided on opposite sides of the second strap cell gate electrode G2 may form The second transistor T2. The first and second transistors T1 and T2 may form the first strap cell S1. In addition, the third strap cell gate electrode G3 on the second active pattern AP2 and the source/drain patterns provided on opposite sides of the third strap cell gate electrode G3 may form the third transistor T3. The fourth strap cell gate electrode G4 on the second active pattern AP2 and the source/drain patterns provided on opposite sides of the fourth strap cell gate electrode G4 may form The fourth transistor T4. The third and fourth transistors T3 and T4 may form the second strap cell S2.

A first wiring layer M1 may be provided within a fourth interlayer dielectric 140. The first wiring layer M1 may include a first gate connection pattern GCP1 provided at a location overlapping gates of the first and second transistors T1 and T2 within the strap element SC, and a second gate connection pattern GCP2 provided at a location overlapping gates of the third and fourth transistors T3 and T4. The first gate connection pattern GCP1 may be connected to the first and second strap cell gate electrodes G1 and G2 through gate contacts CB. The second gate connection pattern GCP2 may be connected to the third and fourth strap cell gate electrodes G3 and G4 through gate contacts CB.

First vias V1 may be provided within a fourth interlayer dielectric 150. The first vias V1 may include strap line connection vias provided in the strap element area. The strap line connection vias may include a first strap line connection via C1 and a second strap line connection via C2, respectively provided on the first and second gate connection patterns GCP1 and GCP2.

A second wiring layer M2 may be provided within a sixth interlayer dielectric 160. The second wiring layer M2 may include the first and second strap cell control lines SCL1 and SCL2. The first and second strap cell control lines SCL1 and SCL2 may be connected to the first and second gate connection patterns GCP1 and GCP2 through the first and second strap line connection vias C1 and C2, respectively.

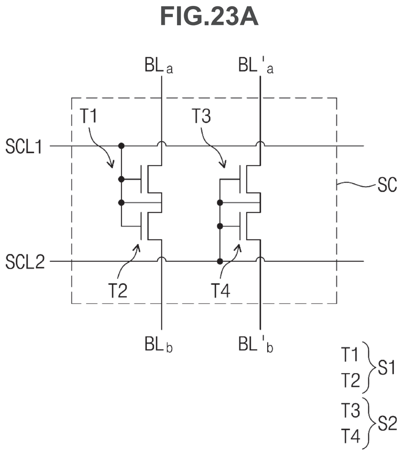

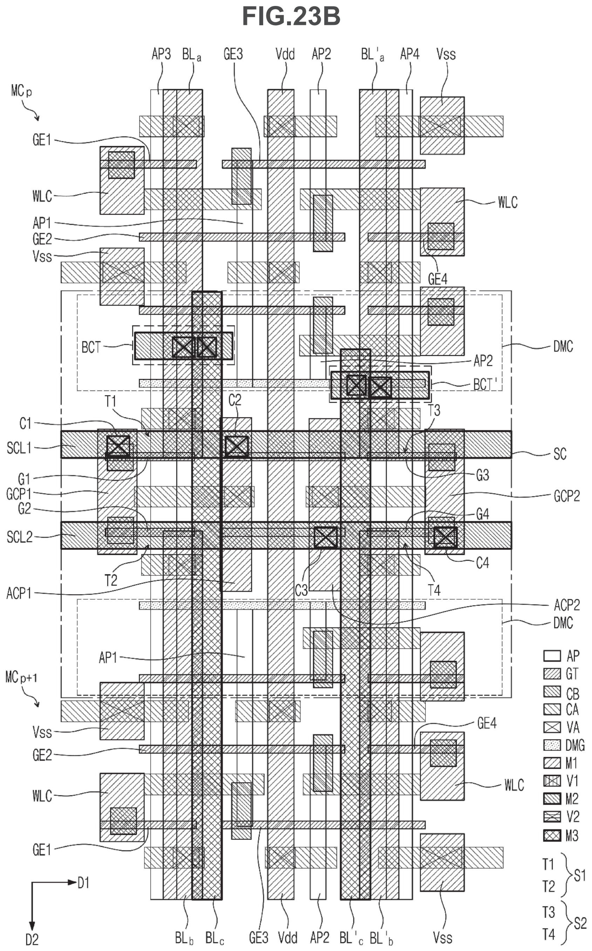

Referring to FIGS. 23A and 23B, a strap element (strap circuit) SC may include two NMOS transistors connected in series to a bitline, as a first strap cell S1 and two NMOS transistors connected in series to a complementary bitline, as a second strap cell S2. For example, two NMOS transistors are connected between a first sub-bitline BLₐ and a second sub-bitline BL_{b} as a first transistor T1 and a second transistor T2. The two NMOS transistors may be connected between a first complementary sub-bitline BL'ₐ and a second complementary sub-bitline BL'_{b} as a third transistor T3 and a fourth transistor T4. The first and second transistors T1 and T2 may form the first strap cell S1, and the third and fourth transistors T3 and T4 may form the second strap cell S2. A first strap cell control line SCL1 may be connected to the gates of the first and second transistors T1 and T2, and between the drain of the first transistor T1 and the source of the second transistor T2. A second strap cell control line SCL2 may be connected to the gates of the third and fourth transistors T3 and T4, and between the drain of the third transistor T3 and the source of the fourth transistor T4. The first and second strap cells S1, S2 may pre-charge/equalize the bitline and the complementary bitline in response to the first strap cell (S1) control signal and the second strap cell (S2) control signal.

In the strap element area, a first strap cell gate electrode G1 and a second strap cell gate electrode may extend in a first direction D1 across a third active pattern AP3. A third strap cell gate electrode G3 and a fourth strap cell gate electrode G4 may extend in the first direction D1 across a fourth active pattern AP4. The first strap cell gate electrode G1 and the third strap cell gate electrode G3 may be spaced apart from each other in the first direction D1. The second strap cell gate electrode and the fourth strap cell gate electrode G4 may also be spaced apart from each other in the first direction D1.

The first strap cell gate electrode G1 and the second strap cell gate electrode G2 may vertically overlap a third channel pattern, and the third strap cell gate electrode G3 and the fourth strap cell gate electrode G4 may vertically overlap a fourth channel pattern.

In the strap element area, the first strap cell gate electrode G1 on the third active pattern AP3 and the source/drain patterns provided on opposite sides of the first strap cell gate electrode G1 may form the first transistor T1. The second strap cell gate electrode G2 on the third active pattern AP3 and the source/drain patterns provided on opposite sides of the third strap cell gate electrode G3 may form the second transistor T2. The first and second transistors T1 and T2 may form the first strap cell S1. In addition, the third strap cell gate electrode G3 on the fourth active pattern AP4 and the source/drain patterns provided on opposite sides of the third strap cell gate electrode G3 may form the third transistor T3. The fourth strap cell gate electrode G4 on the fourth active pattern AP4 and the source/drain patterns provided on opposite sides of the fourth strap cell gate electrode G4 may form the fourth transistor T4. The third and fourth transistors T3 and T4 may form the second strap cell S2.

A first active contact CA may be provided on the third active pattern AP3 between the first and second transistors T1 and T2. A second active contact CA may be provided between the third and fourth transistors T3 and T4. The first and second active contacts CA may extend in the first direction D1.

A first wiring layer M1 may be provided within a fourth interlayer dielectric 140. The first wiring layer M1 may include a first gate connection pattern GCP1 provided at a location overlapping gates of the first and second transistors T1 and T2 within the strap element SC, and a second gate connection pattern GCP2 provided at a location overlapping gates of the third and fourth transistors T3 and T4. The first wiring layer M1 may also include a first active connection pattern connected to the first active contact CA within the strap element SC and a second active connection pattern connected to the second active contact CA.

The first gate connection pattern GCP1 may be connected to the first and second strap cell gate electrodes G1 and G2 through gate contacts CB, and the second gate connection pattern GCP2 may be connected to the third and fourth strap cell gate electrodes G3 and G4 through gate contacts CB. The first active connection pattern and the second active connection pattern may be connected to the first active contact CA and the second active contact CA through active vias VA, respectively.

First vias V1 may be provided within a fourth interlayer dielectric 150. The first vias V1 may include first and second strap line connection vias C1 and C2, respectively provided on the first and second gate connection patterns GCP1 and GCP2, and third strap line vias C3 provided on the first and second active connection patterns.

A second wiring layer M2 may be provided within a sixth interlayer dielectric 160. The second wiring layer M2 may include the first and second strap cell control lines SCL1 and SCL2. The first strap cell control line SCL1 may be connected to the first gate connection patterns GCP1 and the first active connection pattern ACP1 through the first strap line connection vias C1. The second strap cell control line SCL2 may be connected to the second gate connection patterns GCP2 and the second active connection patterns ACP2 through the second strap line connection vias C2.

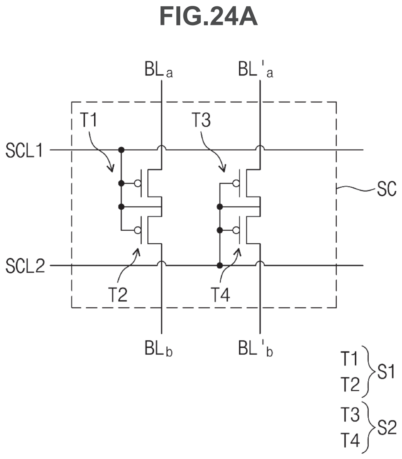

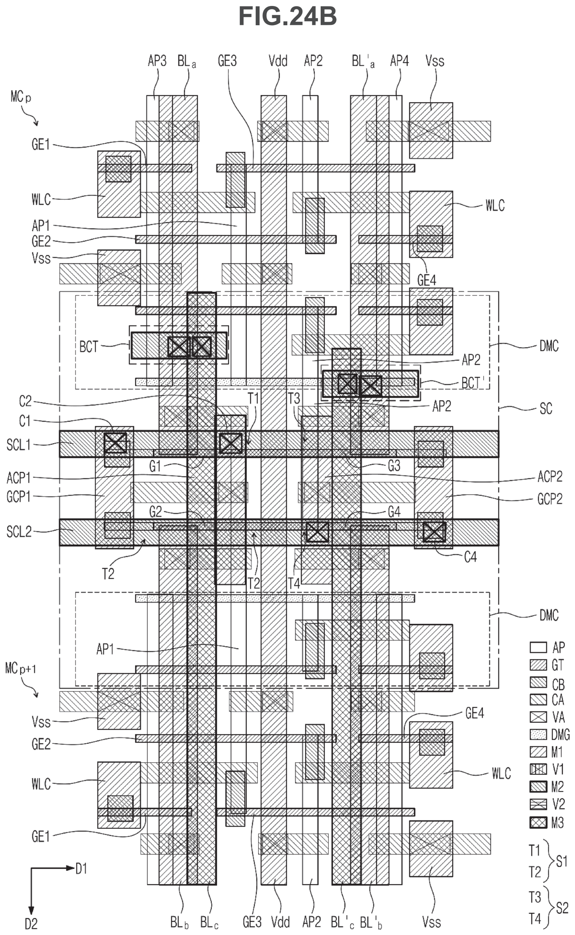

Referring to FIGS. 24A and 24B, the strap element SC may include two PMOS transistors connected in series to a bitline, as a first strap cell S1, and two PMOS transistors connected in series to a complementary bitline, as a second strap cell S2. For example, two PMOS transistors may be connected between a first sub-bitline BLₐ and a second sub-bitline BL_{b}, as a first transistor T1 and a second transistor T2. The two PMOS transistors may be connected between a first complementary sub-bitline BL'ₐ and a second complementary sub-bitline BL'_{b}, as a third transistor T3 and a fourth transistor T4. The first and second transistors T1 and T2 may form the first strap cell S1, and the third and fourth transistors T3 and T4 may form the second strap cell S2. A first strap cell control line SCL1 may be connected to gates of the first and second transistors T1 and T2, and between a drain of the first transistor T1 and a source of the second transistor T2. A second strap cell control line SCL2 may be connected to gates of the third and fourth transistors T3 and T4, and between a drain of the third transistor T3 and a source of the fourth transistor T4. The first and second strap cells S1, S2 may pre-charge/equalize the bitline and the complementary bitline in response to a first strap cell (S1) control signal and a second strap cell (S2) control signal, respectively.

In the strap element area, a first strap cell gate electrode G1 and a second strap cell gate electrode may extend in a first direction D1 across a first active pattern AP1. A third strap cell gate electrode G3 and a fourth strap cell gate electrode G4 may extend in the first direction D1 across a second active pattern AP2. The first strap cell gate electrode G1 and the third strap cell gate electrode G3 may be integrally formed and may extend in the first direction D1. The second strap cell gate electrode and the fourth strap cell gate electrode G4 may also be integrally formed and may extend in the first direction D1.

The first strap cell gate electrode G1 and the second strap cell gate electrode G2 may vertically overlap a first channel pattern, and the third strap cell gate electrode G3 and the fourth strap cell gate electrode G4 may vertically overlap a second channel pattern.

In the strap element area, the first strap cell gate electrode G1 on the first active pattern AP1 and the source/drain patterns provided on opposite sides of the first strap cell gate electrode G1 may form the first transistor T1. The second strap cell gate electrode G2 on the first active pattern AP1 and the source/drain patterns provided on opposite sides of the second strap cell gate electrode G2 may form the second transistor T2. The first and second transistors T1 and T2 may form the first strap cell S1. In addition, the third strap cell gate electrode G3 on the second active pattern AP2 and the source/drain patterns provided on opposite sides of the third strap cell gate electrode G3 may form the third transistor T3. The fourth strap cell gate electrode G4 on the second active pattern AP2 and the source/drain patterns provided on opposite sides of the fourth strap cell gate electrode G4 may the fourth transistor T4. The third and fourth transistors T3 and T4 may form the second strap cell S2.

A first wiring layer M1 may be provided within a fourth interlayer dielectric 140. The first wiring layer M1 may include a first gate connection pattern GCP1 provided at a location overlapping gates of the first and second transistors T1 and T2 within the strap element SC, and a second gate connection pattern GCP2 provided at a location overlapping gates of the third and fourth transistors T3 and T4. The first gate connection pattern GCP1 may be connected to the first and second strap cell gate electrodes G1 and G2 through gate contacts CB, and the second gate connection pattern GCP2 may be connected to the third and fourth strap cell gate electrodes G3 and G4 through gate contacts CB.

First vias V1 may be provided within a fourth interlayer dielectric 150. The first vias V1 may include first and second strap line connection vias C1 and C2, respectively provided on the first and second gate connection patterns GCP1 and GCP2, and a third strap line via C3 provided on the first and second active connection patterns.

A second wiring layer M2 may be provided within a sixth interlayer dielectric 160. The second wiring layer M2 may include the first and second strap cell control lines SCL1, SCL2. The first strap cell control line SCL1 may be connected to the first gate connection patterns GCP1 and the first active connection patterns ACP1 through the first strap line connection vias C1. The second strap cell control line SCL2 may be connected to the second gate connection patterns GCP2 and the second active connection patterns through the second strap line connection vias C2.

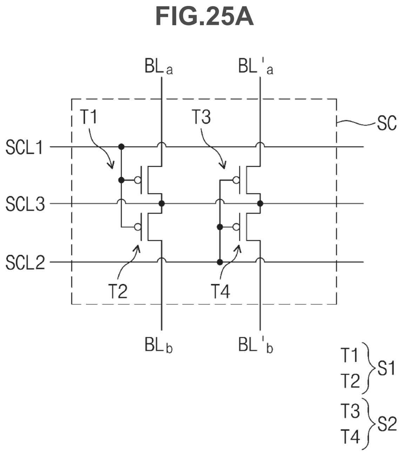

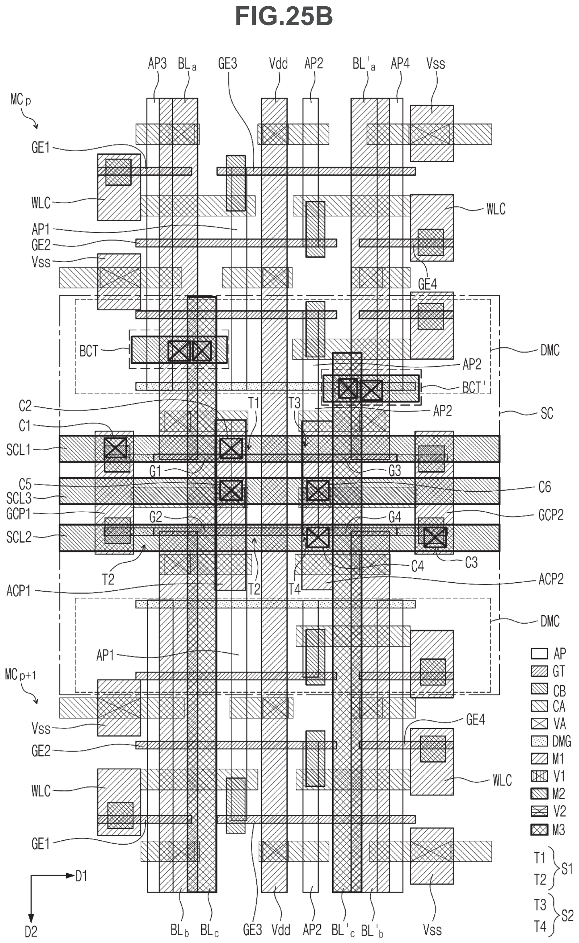

Referring to FIGS. 25A and 25B, a strap element (strap circuit) SC may include two PMOS transistors connected in series to a bitline, as a first strap cell S1, and two PMOS transistors connected in series to a complementary bitline, as a second strap cell S2. For example, two PMOS transistors may be connected between a first sub-bitline BLₐ and a second sub-bitline BL_{b} as a first transistor T1 and a second transistor T2. The two PMOS transistors may be connected between a first complementary sub-bitline BL'ₐ and a second complementary sub-bitline BL'_{b} as a third transistor T3 and a fourth transistor T4. The first and second transistors T1 and T2 may form the first strap cell S1, and the third and fourth transistors T3 and T4 may form the second strap cell S2. A first strap cell control line SCL1 may be connected to gates of the first and second transistors T1 and T2. A second strap cell control line SCL2 may be connected to gates of the third and fourth transistors T3 and T4. A third strap cell control line SCL3 may be connected between a drain of the first transistor T1 and a source of the second transistor T2, and between a drain of the third transistor T3 and a source of the fourth transistor T4. The first and second strap cells S1, S2 may pre-charge/equalize the bitline and the complementary bitline in response to a first strap cell (S1) control signal and a second strap cell (S2) control signal, respectively.

In the strap element area, a first strap cell gate electrode G1 and a second strap cell gate electrode may extend in a first direction D1 across a first active pattern AP1. A third strap cell gate electrode G3 and a fourth strap cell gate electrode G4 may extend in the first direction D1 across a second active pattern AP2. The first strap cell gate electrode G1 and the third strap cell gate electrode G3 may be integrally formed and may extend in the first direction D1. The second strap cell gate electrode and the fourth strap cell gate electrode G4 may also be integrally formed and may extend in the first direction D1.

The first strap cell gate electrode G1 and the second strap cell gate electrode G2 may vertically overlap a first channel pattern, and the third strap cell gate electrode G3 and the fourth strap cell gate electrode G4 may vertically overlap a second channel pattern.

In the strap element area, the first strap cell gate electrode G1 on the first active pattern AP1 and the source/drain patterns provided on opposite sides of the first strap cell gate electrode G1 may form the first transistor T1. The second strap cell gate electrode G2 on the first active pattern AP1 and the source/drain patterns provided on opposite sides of the second strap cell gate electrode G2 may form the second transistor T2. The first and second transistors T1 and T2 may form the first strap cell S1. In addition, the third strap cell gate electrode G3 on the second active pattern AP2 and the source/drain patterns provided on opposite sides of the third strap cell gate electrode G3 may form the third transistor T3. The fourth strap cell gate electrode G4 on the second active pattern AP2 and the source/drain patterns provided on opposite sides of the fourth strap cell gate electrode G4 may form the fourth transistor T4. The third and fourth transistors T3 and T4 may form the second strap cell S2.

A first active contact CA may be provided on the third active pattern AP3 between the first and second transistors T1 and T2. A second active contact CA may be provided between the third and fourth transistors T3 and T4. The first and second active contacts CA may extend in the first direction D1.

A first wiring layer M1 may be provided within a fourth interlayer dielectric 140. The first wiring layer M1 may include a first gate connection pattern GCP1 provided at a location overlapping gates of the first and second transistors T1 and T2 within the strap element SC, and a second gate connection pattern GCP2 provided at a location overlapping gates of the third and fourth transistors T3 and T4. The first wiring layer M1 may also include a first active connection pattern connected to the first active contact CA within the strap element SC and a second active connection pattern connected to the second active contact CA.

The first gate connection pattern GCP1 may be connected to the first and second strap cell gate electrodes G1 and G2 through gate contacts CB, and the second gate connection pattern GCP2 may be connected to the third and fourth strap cell gate electrodes G3 and G4 through gate contacts CB. The first active connection pattern and the second active connection pattern may be connected to the first active contact CA and the second active contact CA through active vias VA, respectively.

First vias V1 may be provided within a fourth interlayer dielectric 150. The first vias V1 may include first and second strap line connection vias C1 and C2, respectively provided on the first and second gate connection patterns GCP1 and GCP2, and a third strap line via C3 provided on the first and second active connection patterns.

A second wiring layer M2 may be provided within a sixth interlayer dielectric 160. The second wiring layer M2 may include first to third strap cell control line SCL1 to SCL3. The first strap cell control line SCL1 may be connected to the first gate connection patterns GCP1 through the first strap line connection vias C1. The second strap cell control line SCL2 may be connected to the second gate connection patterns GCP2 through the second strap line connection vias C2. The third strap cell control line SCL3 may be connected to the first active connection patterns ACP1 and the second active connection patterns through the third strap line vias C3.

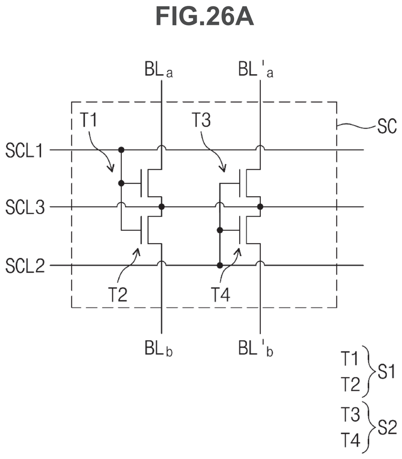

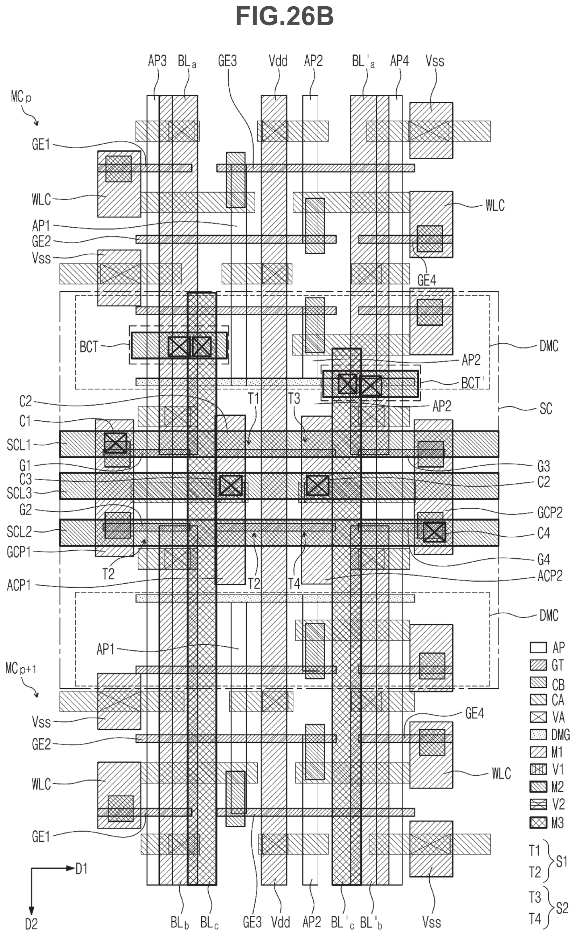

Referring to FIGS. 26A and 26B, a strap element (strap circuit) SC may include two NMOS transistors connected in series to a bitline, as a first strap cell S1 and two NMOS transistors connected in series to a complementary bitline, as a second strap cell S2. For example, two NMOS transistors may be connected between a first sub-bitline BLₐ and a second sub-bitline BL_{b} as a first transistor T1 and a second transistor T2. The two NMOS transistors may be connected between a first complementary sub-bitline BL'ₐ and a second complementary sub-bitline BL'_{b} as a third transistor T3 and a fourth transistor T4. The first and second transistors T1 and T2 may form the first strap cell S1, and the third and fourth transistors T3 and T4 may form the second strap cell S2. A first strap cell control line SCL1 may be connected to the gates of the first and second transistors T1 and T2. A second strap cell control line SCL2 may be connected to gates of the third and fourth transistors T3 and T4. A third strap cell control line SCL3 may be connected between a drain of the first transistor T1 and a source of the second transistor T2, and between a drain of the third transistor T3 and a source of the fourth transistor T4. The first and second strap cells S2 may pre-charge/equalize the bitline and the complementary bitline in response to first to third strap cell control signals.

In the strap element area, a first strap cell gate electrode G1 and a second strap cell gate electrode may extend in a first direction D1 across a third active pattern AP3. A third strap cell gate electrode G3 and a fourth strap cell gate electrode G4 may extend in the first direction D1 across a fourth active pattern AP4. The first strap cell gate electrode G1 and the third strap cell gate electrode G3 may be spaced apart from each other in the first direction D1. The second strap cell gate electrode and the fourth strap cell gate electrode G4 may also be spaced apart from each other in the first direction D1.

The first strap cell gate electrode G1 and the second strap cell gate electrode G2 may vertically overlap a third channel pattern, and the third strap cell gate electrode G3 and the fourth strap cell gate electrode G4 may vertically overlap a fourth channel pattern.

In the strap element area, the first strap cell gate electrode G1 on the third active pattern AP3 and the source/drain patterns provided on opposite sides of the first strap cell gate electrode G1 may form the first transistor T1. The second strap cell gate electrode G2 on the third active pattern AP3 and the source/drain patterns provided on opposite sides of the third strap cell gate electrode G3 may form second transistor T2. The first and second transistors T1 and T2 may form the first strap cell S1. In addition, the third strap cell gate electrode G3 on the fourth active pattern AP4 and the source/drain patterns provided on opposite sides of the third strap cell gate electrode G3 may form the third transistor T3. The fourth strap cell gate electrode G4 on the fourth active pattern AP4 and the source/drain patterns provided on opposite sides of the fourth strap cell gate electrode G4 may form the fourth transistor T4. The third and fourth transistors T3 and T4 may form the second strap cell S2.

A first active contact CA may be provided on the third active pattern AP3 between the first and second transistors T1 and T2. A second active contact CA may be provided between the third and fourth transistors T3 and T4. The first and second active contacts CA may extend in the first direction D1.

A first wiring layer M1 may be provided within a fourth interlayer dielectric 140. The first wiring layer M1 may include a first gate connection pattern GCP1 provided at a location overlapping gates of the first and second transistors T1 and T2 within the strap element SC, and a second gate connection pattern GCP2 provided at a location overlapping gates of the third and fourth transistors T3 and T4. The first wiring layer M1 may also include a first active connection pattern connected to the first active contact CA within the strap element SC and a second active connection pattern connected to the second active contact CA.

The first gate connection pattern GCP1 may be connected to the first and second strap cell gate electrodes G1, G2 through gate contacts CB, and the second gate connection pattern GCP2 may be connected to the third and fourth strap cell gate electrodes G3 and G4 through gate contacts CB. The first active connection pattern and the second active connection pattern may be connected to the first active contact CA and the second active contact CA through active vias VA, respectively.

First vias V1 may be provided within a fourth interlayer dielectric 150. The first vias V1 may include first and second strap line connection vias C1 and C2, respectively provided on the first and second gate connection patterns GCP1 and GCP2, and a third strap line via C3 provided on the first and second active connection patterns.

A second wiring layer M2 may be provided within a sixth interlayer dielectric 160. The second wiring layer M2 may include first, second, and third strap cell control lines SCL1, SCL2, and SCL3. The first strap cell control line SCL1 may be connected to the first gate connection patterns GCP1 through the first strap line connection vias C1. The second strap cell control line SCL2 may be connected to the second gate connection patterns GCP2 through the second strap line connection vias C2. The third strap cell control line SCL3 may be connected to the first active connection patterns ACP1 and the second active connection patterns through the third strap line vias C3.

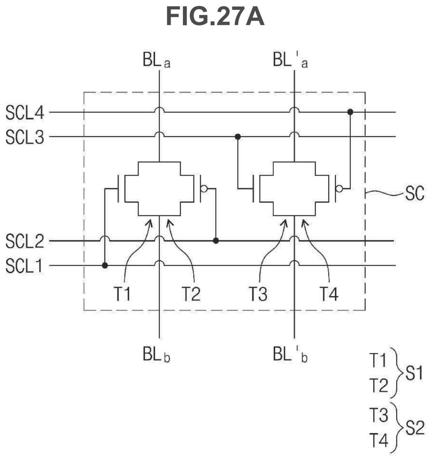

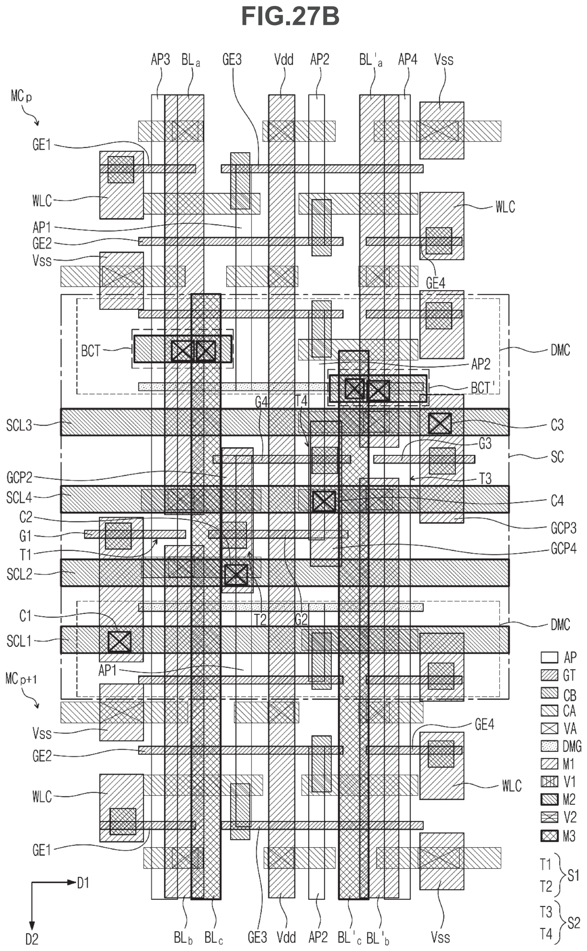

Referring to FIGS. 27A and 27B, a strap element (strap circuit) SC may include a first strap cell S1 connected to a bitline and a second strap cell S2 connected to a complementary bitline. The first strap cell S1 may be a transmission gate in which a first transistor T1, which is an NMOS transistor, and a second transistor T2, which is a PMOS transistor, are connected in parallel. The second strap cell S2 may be a transmission gate in which a third transistor T3, which is an NMOS transistor, and a fourth transistor T4, which is a PMOS transistor, are connected in parallel. Gates of the first to fourth transistors T1, T2, T3, and T4 may be connected to the first to fourth strap cell control lines SCL1, SCL2, SCL3, and SCL4, respectively.

In the strap element area, a first strap cell gate electrode G1 may cross a third active pattern AP3, a second strap cell gate electrode G2 may cross a first active pattern AP1, a third strap cell gate electrode G3 may cross a second active pattern AP2, and a fourth strap cell gate electrode G4 may cross a fourth active pattern AP4. The first strap cell gate electrode G1 and the second strap cell gate electrode G2 may be aligned side by side in a first direction D1. The third strap cell gate electrode G3 and the fourth strap cell gate electrode G4 may be aligned side by side in the first direction D1.

The first strap cell gate electrode G1 may vertically overlap a third channel pattern, the second strap cell gate electrode G2 may vertically overlap a first channel pattern, the third strap cell gate electrode G3 may vertically overlap a second channel pattern, and the fourth strap cell gate electrode G4 may vertically overlap a fourth channel pattern.

In the strap element area, the first strap cell gate electrode G1 on the third active pattern AP3 may be a gate of the first transistor T1 of the strap element SC, the second strap cell gate electrode G2 on the first active pattern AP1 may be a gate of the second transistor T2 of the strap element SC, the third strap cell gate electrode G3 on the second active pattern AP2 may be a gate of the third transistor T3 of the strap element SC, and the fourth strap cell gate electrode G4 on the fourth active pattern AP4 may be a gate of the fourth transistor T4 of the strap element SC.

In the strap element area, the first strap cell gate electrode G1 on the third active pattern AP3 and the source/drain patterns provided on opposite sides of the first strap cell gate electrode G1 may form the first transistor T1. The second strap cell gate electrode G2 on the first active pattern AP1 and the source/drain patterns provided on opposite sides of the first strap cell gate electrode G1 may form the second transistor T2. The first and second transistors T1 and T2 may form the first strap cell S1. In addition, the third strap cell gate electrode G3 on the fourth active pattern AP4 and the source/drain patterns provided on opposite sides of the third strap cell gate electrode G3 may form the third transistor T3. The fourth strap cell gate electrode G4 on the third active pattern AP3 and the source/drain patterns provided on opposite sides of the fourth strap cell gate electrode G4 may form the fourth transistor T4. The third and fourth transistors T3 and T4 may form the second strap cell S2.

A first wiring layer M1 may be provided within a fourth interlayer dielectric 140. The first wiring layer M1 may include first to fourth gate connection patterns GCP1, GCP2, GCP3, and GCP4 provided at locations overlapping the gates of the first to fourth transistors T1, T2, T3, and T4 within the strap element SC. The first to fourth gate connection patterns GCP1, GCP2, GCP3, and GCP4 may be connected to the first to fourth strap cell gate electrodes G1, G2, G3, and G4 through gate contacts CB, respectively.

First vias V1 may be provided within a fourth interlayer dielectric 150. The first vias V1 may include strap line connection vias provided in the strap element area. The strap line connection vias may include first to fourth strap line connection vias C1, C2, C3, and C4 provided on the first to fourth gate connection patterns GCP1, GCP2, GCP3, and GCP4, respectively.

A second wiring layer M2 may be provided within a sixth interlayer dielectric 160. The second wiring layer M2 may include the first to fourth strap cell control lines SCL1, SCL2, SCL3, and SCL4. The first strap cell control line SCL1 may be connected to the first gate connection patterns GCP1 through the first strap line connection vias C1. Similarly, the second to fourth strap cell control lines SCL2, SCL3, and SCL4 may be connected to the second to fourth connection patterns through the second to fourth strap line connection vias C2, C3, and C4.

As set forth above, according to implementations, a memory device facilitating pre-charging of a bitline and a complementary bitline and having a high speed may be provided.

While various implementations have been shown and described above, it will be apparent to those skilled in the art that modifications and variations could be made without departing from the scope of the present inventive concept as defined by the appended claims.

For example, in one or more implementations, a memory cell array has been described as including two sub-memory cell arrays, for example, a first memory cell array and a second memory cell array. However, implementations are not limited thereto, and the memory cell array may include three or more sub-memory cell arrays. In addition, in one or more implementations, the first memory cell array and the second memory cell array are illustrated as having the same number of columns. However, implementations are not limited thereto, and the first and second memory cell arrays may have different numbers of columns.

As used herein, the term "at least one of" can refer to and encompass any and all possible combinations of one or more of the associated listed terms. For example, the term "at least one of A, B, or C" means that (i) at least one of A, (ii) at least one of B, (iii) at least one of C, (iv) at least one of A and at least one of B, (v) at least one of B and at least one of C, (vi) at least one of A and at least one of C, or (vi) at least one of A, at least one of B and at least one of C are possible, where A, B and C may be singular or plural.

While the present disclosure contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Accordingly, the present inventive concepts should not be limited to the contents described in the detailed description but should be defined by the claims.

## Claims

1. A memory device comprising:
a memory cell array comprising memory cells arranged in a matrix, the memory cell array comprising at least one first memory cell (MC1) and at least one second memory cell (MC2) arranged in a column direction;
a first bitline (BL) and a second bitline (BL') connected to each of the at least one first memory cell (MC1) and the at least one second memory cell (MC2); and
a strap circuit (SC) between the at least one first memory cell (MC1) and the at least one second memory cell (MC2),
wherein each of the first bitline (BL) and the second bitline (BL') comprises a first sub-bitline (BLₐ, BL'ₐ) connected to the strap circuit (SC) and the at least one first memory cell (MC1), a second sub-bitline (BL_{b}, BL'_{b}) connected to the strap circuit (SC) and the at least one second memory cell (MC2), and a third sub-bitline (BL_{c}, BL'_{c}) connected to the strap circuit (SC) through the first sub-bitline (BLₐ, BL'ₐ).

2. The memory device of claim 1,
wherein the strap circuit (SC) comprises at least one transistor (T1-T4);
wherein the first sub-bitline (Blₐ, BL'ₐ) and the third sub-bitline (BL_{c}, BL'_{c}) are connected to a source of the at least one transistor (T1-T4); and
wherein the second sub-bitline (BL_{b}, BL'_{b}) is connected to a drain of the at least one transistor (T1-T4).

3. The memory device of claim 1 or 2, wherein the strap circuit (SC) electrically connects the first sub-bitline (BLₐ, BL'ₐ) and the second sub-bitline (BL_{b}, BL'_{b}) in response to a strap circuit control signal.

4. The memory device of any one of claims 1 to 3, wherein the strap circuit (SC) comprises at least one of a transmission gate, a PMOS transistor, or an NMOS transistor.

5. The memory device of any one of claims 1 to 4, wherein the strap circuit (SC) comprises:
a first strap cell (S1) connected to the first bitline (BL); and
a second strap cell (S2)connected to the second bitline (BL').

6. The memory device of claim 5, comprising a strap cell control line (SCL) connected to at least one of the first strap cell (S1) and the second strap cell (S2).

7. The memory device of claim 5, comprising a first strap cell control line (SCL1) connected to the first strap cell (SCL1) and a second strap cell control line (SCL2) connected to the second strap cell (S2).

8. The memory device of claim 7,
wherein the first strap cell (S1) comprises a first transistor (T1) and a second transistor (T2), and the second strap cell (S2) comprises a third transistor (T3) and a fourth transistor (T4);
wherein the first strap cell control line (SCL1) is connected to gates of two transistors among the first transistor (T1), the second transistor (T2), the third transistor (T3), and the fourth transistor (T4); and
wherein the second strap cell control line (SCL2) is connected to gates of remaining two transistors among the first transistor (T1), the second transistor (T2), the third transistor (T3), and the fourth transistor (T4).

9. The memory device of claim 8,
wherein the first transistor (T1) and the second transistor (T2) are connected in series, and the third transistor (T3) and the fourth transistor (T4) are connected in series, and
wherein the memory device comprises a third strap cell control line (SCL3) connected to at least one of a point between the first transistor and the second transistor and a point between the third transistor (T3) and the fourth transistor (T4).

10. The memory device of claim 6,
wherein the first strap cell (S1) comprises a first transistor (T1) and a second transistor (T2), and the second strap cell (S2) comprises a third transistor (T3) and a fourth transistor (T4); and
wherein among the first transistor (T1), the second transistor (T2), the third transistor (T3), and the fourth transistor (T4), two transistors are PMOS transistors and remaining two transistors are NMOS transistors.

11. The memory device of any one of claims 1 to 10, wherein the first sub-bitline (BLₐ, BL'ₐ) and the third sub-bitline (BL_{c}, BL'_{c}) are at vertically different levels.

12. The memory device of claim 11, comprising:
a bitline connection pattern between the first sub-bitline (BLₐ, BL'ₐ) and the third sub-bitline (BL_{c}, BL'_{c}) and configured to electrically connect the first sub-bitline (BLₐ, BL'ₐ) and the third sub-bitline (BL_{c}, BL'_{c}),
wherein the first sub-bitline (BLₐ, BL'ₐ), the bitline connection pattern (BCP), and the third sub-bitline (BL_{c}, BL'_{c}) are disposed at vertically different levels.

13. The memory device of claim 12, wherein the bitline connection pattern (BCP) comprises a plurality of bitline connection patterns (BCP1, BCP2) at vertically different levels, and
wherein the first sub-bitline (BLₐ, BL'ₐ), the second sub-bitline (BL_{b}, BL'_{b}), and third sub-bitline (BL_{c}, BL'_{c}) extend in the column direction.

14. The memory device of any one of claims 1 to 13, comprising:
a pre-charge circuit (23) connected to the first bitline (BL) and the second bitline (BL').

15. The memory device of any one of claims 1 to 14,
wherein the at least one first memory cell comprises a plurality of first memory cells arranged in a matrix to define a first memory cell array (MCA1), and the at least one second memory cell comprises a plurality of second memory cells arranged in a matrix to define a second memory cell array (MCA2); and
wherein the first memory cell array (MCA1), the strap circuit (SC), and the second memory cell array (MCA2) are sequentially arranged in the column direction.
